(19) Europäisches Patentamt
European Patent Office
Office européen des brevets

(11) **EP 3 556 822 A1**

(12) **EUROPEAN PATENT APPLICATION**

(43) Date of publication:
**23.10.2019 Bulletin 2019/43**

(51) Int Cl.:
***C09K 8/584*** *(2006.01)* ***C09K 8/588*** *(2006.01)*
***E21B 43/16*** *(2006.01)*

(21) Application number: **19170334.7**

(22) Date of filing: **18.04.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **20.04.2018 US 201862660746 P**

(71) Applicant: **Chevron U.S.A. Inc.**
**San Ramon, California 94583-0806 (US)**

(72) Inventors:
- **GHOSH, Soumyadeep**
  **San Ramon, California 94583 (US)**
- **NAJAFABADI, Nariman Fathi**
  **San Ramon, California 94583 (US)**
- **CHAWATHE, Adwait**
  **San Ramon, California 94583 (US)**
- **THACH, Sophany**
  **San Ramon, California 94583 (US)**
- **AMBASTHA, Anil**
  **San Ramon, California 94583 (US)**

(74) Representative: **Haseltine Lake Kempner LLP**
**Redcliff Quay**
**120 Redcliff Street**
**Bristol BS1 6HU (GB)**

(54) **PARTITIONING POLYMER INTO PHASES OF A MICROEMULSION SYSTEM**

(57) One embodiment includes generating a polymer partitioning model that determines a concentration of the polymer in a brine phase of the microemulsion system and a concentration of the polymer in an aqueous component of a microemulsion phase of the microemulsion system. The embodiment includes determining a viscosity of the brine phase of the microemulsion system using the concentration of the polymer in the brine phase of the microemulsion system, determining a viscosity of the aqueous component of the microemulsion phase of the microemulsion system using the concentration of the polymer in the aqueous component of the microemulsion phase of the microemulsion system, and determining a viscosity of the microemulsion phase of the microemulsion system using the viscosity of the aqueous component of the microemulsion phase of the microemulsion system. The embodiment includes using determined viscosities to determine performance of a chemical enhanced oil recovery process scenario.

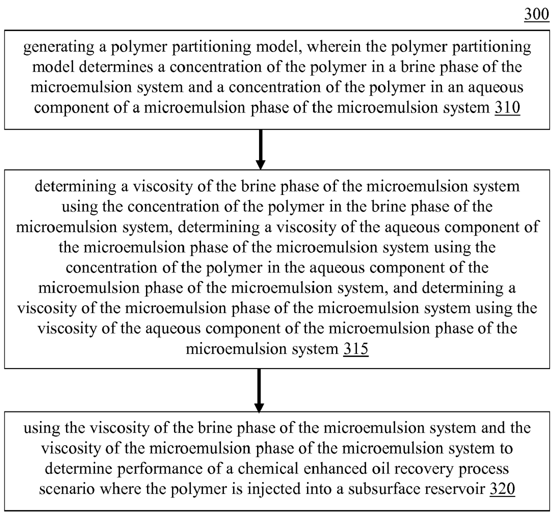


**FIG. 3**

EP 3 556 822 A1

**Description**

## CROSS REFERENCES TO RELATED APPLICATIONS

This application claims benefit under 35 USC 119 of U.S. Provisional Patent App. No. 62/660746 (Docket No. T-10826-P) with a filing date of April 20, 2018, which is incorporated by reference in its entirety and for all purposes.

## STATEMENT REGARDING FEDERALLY SPONSORED RESEARCH OR DEVELOPMENT

Not applicable.

## TECHNICAL FIELD

The present disclosure relates generally to chemical enhanced oil recovery. In particular, the present disclosure relates to determining partitioning of a polymer into phases of a microemulsion system in a chemical enhanced oil recovery process.

## BACKGROUND

A subsurface reservoir typically contains fluids such as water and hydrocarbons like oil and gas. To remove ("produce") the hydrocarbons from the reservoir, different mechanisms can be utilized such as primary, secondary, or tertiary processes. In a primary recovery process, hydrocarbons are displaced from the reservoir through the high natural differential pressure between the reservoir and the bottom-hole pressure within a wellbore. In order to increase the production life of the reservoir, secondary or tertiary recovery processes can be used such as, but not limited to, "improved oil recovery" (IOR), "enhanced oil recovery" (EOR), or "chemical enhanced oil recovery" (CEOR).

In chemical enhanced oil recovery processes, a chemical solution (e.g., an injection fluid including a polymer, a surfactant, a co-surfactant, an alkali, a co-solvent, or any combination thereof) is injected into the subsurface reservoir. For example, in polymer flooding or surfactant polymer flooding processes, the polymer and surfactant mix with the fluid present in the reservoir forming microemulsion systems having one or more fluid phases. Various types of microemulsion systems may form. In particular, a single-phase system, a two-phase system, or a three-phase system are possible. The single-phase system includes a microemulsion phase. The two-phase system can include a microemulsion phase and an excess oil phase (or simply "oil phase"). Alternatively, the two-phase system can include a microemulsion phase and an excess brine phase (or simply "brine phase"). The three-phase system includes a microemulsion phase, an excess oil phase, and an excess brine phase. Furthermore, the microemulsion phase has an aqueous component. The number of phases formed and the composition(s) of the phases vary depending upon variables associated with the microemulsion system, for example, the salinity, the polymer formulation, the surfactant formulation, temperature, pressure, etc.

It is desirable to model polymer in chemical enhanced oil recovery processes in order to perform reservoir simulations and forecast field scale oil recovery. Accurately predicting polymer behavior in a microemulsion system can shorten the laboratory screening process used in the design of chemical solutions (e.g., polymer formulations) used in chemical enhanced oil recovery processes. However, conventional techniques have limitations with respect to the extent to which they accurately represent or predict real-world behavior of the polymer. Accordingly, their predictive capabilities are limited.

The ability to deal with the polymer is crucial to our ability to make the most appropriate decisions for purchasing materials, operating safely, and successfully completing projects. Decisions include, but are not limited to, determining concentration of the polymer to be injected, designing well paths and drilling strategy, preventing subsurface integrity issues by planning proper casing and cementation strategies, selecting and purchasing appropriate completion and production equipment, and budgetary planning.

Accordingly, there is a need for an improved method of predicting and modeling polymer in chemical enhanced oil recovery processes.

## SUMMARY

The embodiments provided herein relate to determining partitioning of a polymer into phases of a microemulsion system.

One embodiment of a computer implemented method of determining partitioning of a polymer into phases of a microemulsion system is provided herein. The embodiment comprises (a) generating a polymer partitioning model. The polymer partitioning model determines a concentration of the polymer in a brine phase of the microemulsion system and a concentration of the polymer in an aqueous component of a microemulsion phase of the microemulsion system. The embodiment further comprises (b) determining a viscosity of the brine phase of the microemulsion system using the concentration of the polymer in the brine phase of the microemulsion system, determining a viscosity of the aqueous component of the microemulsion phase of the microemulsion system using the concentration of the polymer in the aqueous component of the microemulsion phase of the microemulsion system, and determining a viscosity of the microemulsion phase of the microemulsion system using the viscosity of the aqueous component of the microemulsion phase of the microemulsion system. The embodiment further comprises (c) using the viscosity of the brine phase of the microemulsion system and the viscosity of the microemulsion phase of the microemulsion system to determine performance of a chemical enhanced oil recovery process scenario where the polymer is injected into a subsurface reservoir.

One embodiment of a system comprises a processor and a memory operatively connected to the processor, the memory storing instructions that, when executed by the processor, cause the system to perform a method of determining partitioning of a polymer into phases of a microemulsion system, is provided herein. The method comprises (a) generating a polymer partitioning model. The polymer partitioning model determines a concentration of the polymer in a brine phase of the microemulsion system and a concentration of the polymer in an aqueous component of a microemulsion phase of the microemulsion system. The method further comprises (b) determining a viscosity of the brine phase of the microemulsion system using the concentration of the polymer in the brine phase of the microemulsion system, determining a viscosity of the aqueous component of the microemulsion phase of the microemulsion system using the concentration of the polymer in the aqueous component of the microemulsion phase of the microemulsion system, and determining viscosity of the microemulsion phase of the microemulsion system using the viscosity of the aqueous component of the microemulsion phase of the microemulsion system. The method further comprises (c) using the viscosity of the brine phase of the microemulsion system and the viscosity of the microemulsion phase of the microemulsion system to determine performance of a chemical enhanced oil recovery process scenario where the polymer is injected into a subsurface reservoir.

One embodiment of a non-transitory computer-readable medium storing instructions that, when executed by a computer, cause the computer to perform a method of determining partitioning of a polymer into phases of a microemulsion system, is provided herein. The method comprises (a) generating a polymer partitioning model, wherein the polymer partitioning model determines a concentration of the polymer in a brine phase of the microemulsion system and a concentration of the polymer in an aqueous component of a microemulsion phase of the microemulsion system. The method further comprises (b) determining a viscosity of the brine phase of the microemulsion system using the concentration of the polymer in the brine phase of the microemulsion system, determining a viscosity of the aqueous component of the microemulsion phase of the microemulsion system using the concentration of the polymer in the aqueous component of the microemulsion phase of the microemulsion system, and determining a viscosity of the microemulsion phase of the microemulsion system using the viscosity of the aqueous component of the microemulsion phase of the microemulsion system. The method further comprises (c) using the viscosity of the brine phase of the microemulsion system and the viscosity of the microemulsion phase of the microemulsion system to determine performance of a chemical enhanced oil recovery process scenario where the polymer is injected into a subsurface reservoir.

## DESCRIPTION OF THE DRAWINGS

FIG. 1A is a diagram that illustrates a conventional technique for predicting microemulsion viscosity when the microemulsion system contains a polymer. FIG. 1B is a diagram that provides one embodiment of determining partitioning of a polymer into phases of a microemulsion system. FIG. 1B also illustrates differences as compared to the conventional technique illustrated in FIG. 1A. FIG. 1C is a diagram of one embodiment of an application of improved viscosity prediction using a polymer partitioning model. FIG. 1D is a diagram of one embodiment of a process of interpreting experimental data from the laboratory to predict improved microemulsion phase viscosities. FIG. 1E is a diagram of one embodiment of a process of using an improved viscosity model in simulations to result in improved chemical enhanced oil recovery predictions. FIG. 1F is a diagram of one embodiment of improved simulation results, enhancing performance prediction of chemical enhanced oil recovery.

FIG. 2 illustrates one embodiment of a computing system of determining partitioning of a polymer into phases of a microemulsion system.

FIG. 3 illustrates one embodiment of a method of determining partitioning of a polymer into phases of a microemulsion system.

FIG. 4 illustrates an example of a polymer partitioning coefficient as a function of brine phase saturation.

FIG. 5 illustrates another example of a polymer partitioning coefficient as a function of brine phase saturation.

FIGS. 6A-6D illustrate examples of concentrations of the polymer in the brine phase and concentrations of the polymer in the aqueous component of the microemulsion phase that may be calculated using FIG. 5.

FIGS. 7A-7D illustrate examples of viscosities of the microemulsion phase that may be calculated using FIG. 5.
FIG. 8 schematically illustrates an example of a subsurface reservoir and examples of wellbores drilled into the subsurface reservoir.

Reference will now be made in detail to various embodiments, where like reference numerals designate corresponding parts throughout the several views. In the following detailed description, numerous specific details are set forth in order to provide a thorough understanding of the present disclosure and the embodiments described herein. However, embodiments described herein may be practiced without these specific details. In other instances, well-known methods, procedures, components, and mechanical apparatus have not been described in detail so as not to unnecessarily obscure aspects of the embodiments.

## DETAILED DESCRIPTION

**TERMINOLOGY:** The following terms will be used throughout the specification and will have the following meanings unless otherwise indicated.

"Subsurface" refers to practically anything below a surface, such as below the earth's surface, below the ocean's surface, below a water's surface, etc. The subsurface may include faults, fractures, overburdens, underburdens, salts, salt welds, rocks, sands, sediments, pore space, etc. The subsurface may be onshore, offshore (e.g., shallow water or deep water), etc. Indeed, it should be appreciated that the term "subsurface," as used herein, may include practically any geologic points or volume(s) of interest (such as a survey area).

Furthermore, the subsurface may include hydrocarbons, such as liquid hydrocarbons (also known as oil or petroleum), gas hydrocarbons (e.g., natural gas), a combination of liquid hydrocarbons and gas hydrocarbons, etc. One measure of the heaviness or lightness of a liquid hydrocarbon is American Petroleum Institute (API) gravity. According to this scale, light crude oil is defined as having an API gravity greater than 31.1° API (less than 870 kg/m3), medium oil is defined as having an API gravity between 22.3° API and 31.1° API (870 to 920 kg/m3), heavy crude oil is defined as having an API gravity between 10.0° API and 22.3° API (920 to 1000 kg/m3), and extra heavy oil is defined with API gravity below 10.0° API (greater than 1000 kg/m3). Light crude oil, medium oil, heavy crude oil, and extra heavy oil are examples of hydrocarbons. Thus, examples of hydrocarbons are many, and may include, conventional oil, heavy oil, natural gas, kerogen, bitumen, clathrates (or hydrates), etc.

The hydrocarbons may be recovered from the entire subsurface or from a portion of the subsurface. For example, the subsurface may be divided up into one or more hydrocarbon zones, and hydrocarbons can be recovered from each desired hydrocarbon zone. In some embodiments, one or more of hydrocarbon zones may even be shut in to increase hydrocarbon recovery from a hydrocarbon zone that is not shut in.

The hydrocarbons may be recovered from the subsurface using primary recovery (e.g., by relying on pressure to recover hydrocarbons), secondary recovery (e.g., by using water injection (also referred to as waterflooding) or natural gas injection to recover hydrocarbons), enhanced oil recovery (EOR), or any combination thereof. The term "enhanced oil recovery" refers to techniques for increasing the amount of hydrocarbons that may be extracted from the subsurface. Enhanced oil recovery may also be referred to as improved oil recovery or tertiary oil recovery.

Examples of EOR processes include, for example: (a) miscible gas injection (which includes, for example, carbon dioxide flooding), (b) chemical injection (sometimes referred to as chemical enhanced oil recovery (CEOR), and which includes, for example, polymer flooding, alkaline flooding, surfactant flooding, conformance control, as well as combinations thereof such as alkaline-polymer flooding, surfactant-polymer flooding, or alkaline-surfactant-polymer flooding), (c) microbial injection, (d) thermal recovery (which includes, for example, cyclic steam and steam flooding), or any combination thereof.

The CEOR process can include practically any flooding involving polymer, such as, but not limited to, a polymer (P) flooding process, an alkaline-polymer (AP) flooding process, a surfactant-polymer (SP) flooding process, an alkaline-surfactant-polymer (ASP) flooding process, or any combination thereof. The term "polymer" refers to practically any polymer that may be injected into a subsurface reservoir. For example, the polymer can be initially provided as a powder that is mixed on-site by at least one mixer, or the polymer can be initially provided in a partial-strength solution, such as gel, emulsion, or other fluid that is made up partly of polymer (e.g., 2%-60% polymer) in a solute such as water or a brine.

Regarding the polymer, a powder polymer may be selected or tailored according to the characteristics of the subsurface reservoir such as permeability, temperature, and salinity. Examples of suitable powder polymers include biopolymers such as polysaccharides. For example, polysaccharides can be xanthan gum, scleroglucan, guar gum, schizophyllan, any derivative thereof (e.g., such as a modified chain), or any combination thereof. Examples of suitable powder synthetic polymers include polyacrylamides. Examples of suitable powder polymers include synthetic polymers such as partially hydrolyzed polyacrylamides (HPAMs or PHPAs) and hydrophobically-modified associative polymers (APs). Also included are copolymers of polyacrylamide (PAM) and one or both of 2-acrylamido 2-methylpropane sulfonic acid (and/or sodium salt) commonly referred to as AMPS (also more generally known as acrylamido tertiobutyl sulfonic acid or ATBS), N-vinyl pyrrolidone (NVP), and the NVP-based synthetic may be single-, co-, or ter-polymers. In one embodiment, the powder synthetic polymer comprises polyacrylic acid (PAA). In one embodiment, the powder synthetic polymer comprises polyvinyl alcohol (PVA). Copolymers may be made of any combination or mixture above, for example, a combination of NVP and ATBS. Thus, examples of suitable powder polymers include biopolymers or synthetic polymers. Examples of suitable powder polymers can also include any mixture of these powder polymers (including any modifications of these powder polymers).

Examples of polymers are discussed in the following: US Patent No. 9,909,053 (Docket No. T-9845A), US Patent No. 9,896,617 (Docket No. T-9845B), US Patent No. 9,902,894 (Docket No. T-9845C), US Patent No. 9,902,895 (Docket No. T-9846), US Patent Application Publication No. 2018/0031462 (Docket No. T-10484), US Patent Application Serial No. 15/511,563 (also available as WO2017040903A1) (Docket No. T-10079), each of which is incorporated by reference in its entirety. More examples of polymers may be found in Dwarakanath et al., "Permeability Reduction Due to use of Liquid Polymers and Development of Remediation Options," SPE 179657, SPE IOR Symposium in Tulsa, 2016, which is incorporated by reference in its entirety.

An injection fluid can be mixed on-site to include the polymer, e.g., by mixing the polymer in the form of a powder, gel, emulsion, or liquid, with a solute such as water. As discussed hereinabove, the powder polymer may involve at least one additional mixing step and storage of the result in a tank (e.g., tank on the surface). The result from the tank is then combined with the solute to form the injection fluid. The injection fluid is injected into the wellbore through a wellhead of the wellbore using at least one pump. The physical equipment to be used in mixing and injecting is dependent on the polymer, the wellbore, the subsurface reservoir, etc., but for simplicity, the tank, the mixer, the wellhead, the pump, and other items related to mixing and injecting the injection fluid will just be referred to herein as "injection apparatus."

The hydrocarbons may also be recovered from the subsurface using radio frequency (RF) heating. For example, at least one radio frequency antenna may be utilized to increase the temperature of the oil and reduce the oil's viscosity. The oil can then be produced from the subsurface with an improved oil flow rate. Radio frequency may also be used in combination with at least one other recovery technique, such as steam flooding, as described in U.S. Patent No. 9,284,826 (Attorney Dkt. No. T-9292), which is incorporated by reference in its entirety.

The hydrocarbons may also be recovered from the subsurface using fracturing. For example, fracturing may include hydraulic fracturing, fracturing using electrodes such as described in U.S. Patent No. 9,840,898 (Attorney Dkt. No. T-9622B), etc. Fracturing may also be used in combination with at least one other recovery technique. Fracturing may be used to recover hydrocarbons from new reservoirs. Fracturing may also be used to help recover hydrocarbons from mature fields, for example, by waterflooding or steamflooding the mature fields after fracturing the mature fields. Mature fields are broadly defined as hydrocarbon fields where production has already peaked and production is currently declining.

The subsurface, the hydrocarbons, or both may also include non-hydrocarbon items. For example, non-hydrocarbon items may include connate water, brine, tracers, items used in enhanced oil recovery (e.g., polymer and fluid used in a chemical enhanced oil recovery process), items from other types of treatments (e.g., gels used in conformance control), etc.

In short, each subsurface may have a variety of characteristics, such as petrophysical rock properties, reservoir fluid properties, reservoir conditions, or any combination thereof. For example, each subsurface may be associated with one or more of: temperature, porosity, permeability, water composition, mineralogy, hydrocarbon type, hydrocarbon quantity, reservoir location, pressure, etc. Indeed, those of ordinary skill in the art will appreciate that the characteristics are many, including, for example: tight gas, shale gas, tight oil, tight carbonate, diatomite, geothermal, coalbed methane, a methane hydrate containing subsurface, a mineral containing subsurface, a metal containing subsurface, a subsurface having a permeability in the range of 0.01 microdarcy to 10 millidarcy, a subsurface having a permeability in the range of 10 millidarcy to 40,000 millidarcy, etc. The term "subsurface" may be used synonymously with the term "reservoir" or "formation" or "subsurface reservoir". The terms "subsurface," "hydrocarbon," and the like are not limited to any description or configuration described herein.

"Wellbore" refers to a single hole for use in hydrocarbon recovery. For example, a wellbore may be a cylindrical hole drilled into the subsurface such that the wellbore is surrounded by the subsurface. The wellbore may also be perforated for fluidic communication with the subsurface. The wellbore may be used for injection in some embodiments. The wellbore may be used for production in some embodiments. The wellbore may be used for fracturing in some embodiments. The wellbore may be used for a single function, such as only injection, in some embodiments. The wellbore may be used for a plurality of functions, such as both injection and production in some embodiments. Oftentimes, the hydrocarbons may be swept from a single injection wellbore towards at least one production wellbore and then up towards the surface. The wellbore may be drilled amongst existing wellbores as an infill wellbore. A plurality of wellbores (e.g., tens to hundreds of wellbores) are oftentimes used in a field to recover hydrocarbons from the subsurface.

The wellbore may include a plurality of components, such as, but not limited to, a casing, a liner, a tubing string, a heating element, a wellhead, a tree, a sensor, a packer, a screen, a gravel pack, etc. The "casing" refers to a steel pipe cemented in place during the wellbore construction process to stabilize the wellbore. The "liner" refers to any string of casing in which the top does not extend to the surface but instead is suspended from inside the previous casing. The "tubing string" or simply "tubing" is made up of a plurality of tubulars (e.g., tubing, tubing joints, pup joints, etc.) connected together. The tubing string is lowered into the casing or the liner for injecting a fluid into the subsurface, producing a fluid from the subsurface, or any combination thereof. The casing may be cemented into the wellbore with the cement placed in the annulus between the subsurface and the outside of the casing. The tubing string and the liner are typically not cemented in the wellbore. The wellbore may also include any completion hardware that is not discussed separately. If the wellbore is drilled offshore, for example, the wellbore may include some of the previous components plus other components such as a riser, an umbilical, a subsea manifold, a subsea tree, remotely operated vehicle (ROV), etc.

The wellbore may have vertical, horizontal, or combination trajectories. For example, the wellbore may be a vertical wellbore, a horizontal wellbore, a multilateral wellbore, an inclined wellbore, a slanted wellbore, etc.

The wellbore may include a "build section." "Build section" refers to practically any section of a wellbore where the deviation is changing. As an example, the deviation is changing when the wellbore is curving. In a horizontal wellbore, the build section is the curved section between the vertical section of the horizontal wellbore and the horizontal section of the horizontal wellbore. Wellbores that are not horizontal wellbores may also include a build section. For example, inclined or slanted wellbores may each include a build section. In some embodiments, a build section may exist in a wellbore when there is a deviation in the order of at least one seismic wave. In short, a section of a wellbore where the wellbore's angle is changing may be referred to as a "build section". Of note, those of ordinary skill in the art will appreciate that the build section of the wellbore may also include the subsurface in the vicinity of the build section of the wellbore in some embodiments.

The wellbore may be drilled into the subsurface using practically any drilling technique and equipment known in the art, such as geosteering, directional drilling, etc. For example, drilling the wellbore may include using a tool such as a drilling tool. The drilling tool may include a drill bit and a drill string. Drilling fluid may be used while drilling. One or more tools may additionally be used while drilling or after drilling, such as measurement-while-drilling (MWD) tools, seismic-while-drilling (SWD) tools, wireline tools, logging-while-drilling (LWD) tools, or other downhole or reservoir tools. After drilling to a predetermined depth, the drill string and drill bit are removed, and then the casing, the tubing, etc. may be installed according to the design of the wellbore. The equipment to be used in drilling may depend on the wellbore design, the subsurface reservoir, the hydrocarbons, etc., but for simplicity, the drill bit, the drill string, and other items related to drilling will just be referred herein as "drilling apparatus."

Some embodiments of wellbores may also be found in U.S. Patent Application Publication No. 2014/0288909 (Attorney Dkt. No. T-9407) and U.S. Patent Application Publication No. 2017/0058186 (Attorney Dkt. No. T-10197), each of which is incorporated by reference in its entirety. The term "wellbore" may be used synonymously with the terms "borehole," "well," or "well bore." The term "wellbore" is not limited to any description or configuration described herein.

As used in this specification and the following claims, the term "proximate" is defined as "near". If item A is proximate to item B, then item A is near item B. For example, in some embodiments, item A may be in contact with item B. For example, in some embodiments, there may be at least one barrier between item A and item B such that item A and item B are near each other, but not in contact with each other. The barrier may be a fluid barrier, a non-fluid barrier (e.g., a structural barrier), or any combination thereof. Both scenarios are contemplated within the meaning of the term "proximate."

As used in this specification and the following claims, the terms "comprise" (as well as forms, derivatives, or variations thereof, such as "comprising" and "comprises") and "include" (as well as forms, derivatives, or variations thereof, such as "including" and "includes") are inclusive (i.e., open-ended) and do not exclude additional elements or steps. For example, the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. Accordingly, these terms are intended to not only cover the recited element(s) or step(s), but may also include other elements or steps not expressly recited. Furthermore, as used herein, the use of the terms "a" or "an" when used in conjunction with an element may mean "one," but it is also consistent with the meaning of "one or more," "at least one," and "one or more than one." Therefore, an element preceded by "a" or "an" does not, without more constraints, preclude the existence of additional identical elements.

The use of the term "about" applies to all numeric values, whether or not explicitly indicated. This term generally refers to a range of numbers that one of ordinary skill in the art would consider as a reasonable amount of deviation to the recited numeric values (i.e., having the equivalent function or result). For example, this term can be construed as including a deviation of $\pm 10$ percent of the given numeric value provided such a deviation does not alter the end function or result of the value. Therefore, a value of about 1% can be construed to be a range from 0.9% to 1.1%. Furthermore, a range may be construed to include the start and the end of the range. For example, a range of 10% to 20% (i.e., range of 10%-20%) includes 10% and also includes 20%, and includes percentages in between 10% and 20%, unless explicitly stated otherwise herein.

As used herein, the term "if' may be construed to mean "when" or "upon" or "in response to determining" or "in accordance with a determination" or "in response to detecting," that a stated condition precedent is true, depending on the context. Similarly, the phrase "if it is determined [that a stated condition precedent is true]" or "if [a stated condition precedent is true]" or "when [a stated condition precedent is true]" may be construed to mean "upon determining" or "in response to determining" or "in accordance with a determination" or "upon detecting" or "in response to detecting" that the stated condition precedent is true, depending on the context.

It is understood that when combinations, subsets, groups, etc. of elements are disclosed (e.g., combinations of components in a composition, or combinations of steps in a method), that while specific reference of each of the various individual and collective combinations and permutations of these elements may not be explicitly disclosed, each is specifically contemplated and described herein. By way of example, if an item is described herein as including a component of type A, a component of type B, a component of type C, or any combination thereof, it is understood that this phrase describes all of the various individual and collective combinations and permutations of these components. For example, in some embodiments, the item described by this phrase could include only a component of type A. In some embodiments, the item described by this phrase could include only a component of type B. In some embodiments, the item described by this phrase could include only a component of type C. In some embodiments, the item described by this phrase could include a component of type A and a component of type B. In some embodiments, the item described by this phrase could include a component of type A and a component of type C. In some embodiments, the item described by this phrase could include a component of type B and a component of type C. In some embodiments, the item described by this phrase could include a component of type A, a component of type B, and a component of type C. In some embodiments, the item described by this phrase could include two or more components of type A (e.g., A1 and A2). In some embodiments, the item described by this phrase could include two or more components of type B (e.g., B1 and B2). In some embodiments, the item described by this phrase could include two or more components of type C (e.g., C1 and C2). In some embodiments, the item described by this phrase could include two or more of a first component (e.g., two or more components of type A (A1 and A2)), optionally one or more of a second component (e.g., optionally one or more components of type B), and optionally one or more of a third component (e.g., optionally one or more components of type C). In some embodiments, the item described by this phrase could include two or more of a first component (e.g., two or more components of type B (B1 and B2)), optionally one or more of a second component (e.g., optionally one or more components of type A), and optionally one or more of a third component (e.g., optionally one or more components of type C). In some embodiments, the item described by this phrase could include two or more of a first component (e.g., two or more components of type C (C1 and C2)), optionally one or more of a second component (e.g., optionally one or more components of type A), and optionally one or more of a third component (e.g., optionally one or more components of type B).

Although some of the various drawings illustrate a number of logical stages in a particular order, stages that are not order dependent may be reordered and other stages may be combined or broken out. While some reordering or other groupings are specifically mentioned, others will be obvious to those of ordinary skill in the art and so do not present an exhaustive list of alternatives. Moreover, it should be recognized that the stages could be implemented in hardware, firmware, software, or any combination thereof.

Unless defined otherwise, all technical and scientific terms used herein have the same meanings as commonly understood by one of skill in the art to which the disclosed invention belongs. All citations referred herein are expressly incorporated by reference.

**OVERVIEW:** In a chemical enhanced oil recovery process, the polymer increases phase viscosity and enhances sweep efficiency. And if a surfactant is utilized, the surfactant aids in overcoming capillary forces that trap oil in porous rocks, thereby improving displacement efficiency. The state-of-the-art is to consider a system with three pseudocomponents (surfactant, oil, and brine). In these systems, phase behavior allows for a maximum number of three phases, namely, the microemulsion phase, the (excess) oil phase, and the (excess) brine phase. Polymer is not considered to be a separate pseudocomponent, and therefore, the conventional techniques simply consider polymer to be dispersed evenly within the water components in the brine phase and the microemulsion phase. Indeed, such a rule allows for the polymer concentration in the aqueous component in the microemulsion phase to be the same as the polymer concentration in the brine phase.

Unfortunately, substantial experimental data indicates that such an assumption overpredicts microemulsion viscosity in certain bicontinuous and oil-rich microemulsions, which leads to incorrect flood design. Although some have attempted to solve this issue, for example, with a correction factor that predicts physical microemulsion viscosities, there is still a need for improvement. For example, the correction factor does not offer a physical solution to partition polymer between the phases of the microemulsion system. As illustrated in FIG. 1A, conventional techniques do not partition the polymer.

Provided herein are embodiments of methods and systems of determining partitioning of a polymer into phases of a microemulsion system. The embodiments provided herein partition the polymer between the aqueous component of the microemulsion phase and the brine phase in a physical manner, thereby resulting in an improved microemulsion viscosity prediction (e.g., that is consistent with experimental data). Prediction of correct viscosity is essential to design chemical enhanced oil recovery processes in real field applications. FIG. 1B is a diagram that provides one embodiment of determining partitioning of a polymer into phases of a microemulsion system as explained further herein. FIG. 1B also illustrates differences as compared to the conventional technique illustrated in FIG. 1A. FIG. 1C is a diagram of one embodiment of an application of improved viscosity prediction using a polymer partitioning model. FIG. 1D is a diagram of one embodiment of a process of interpreting experimental data from the laboratory to predict improved microemulsion phase viscosities. FIG. 1E is a diagram of one embodiment of a process of using an improved viscosity model in simulations to result in improved chemical enhanced oil recovery predictions. FIG. 1F is a diagram of one embodiment of improved simulation results, enhancing performance prediction of chemical enhanced oil recovery. Of note, the examples illustrated in FIGS. 1E-1F are synthetic.

Advantageously, the polymer partitioning embodiments provided herein may be utilized to generate more accurate values. For example, the embodiments provided herein may be utilized to generate more accurate values for the viscosity of the brine phase of the microemulsion system and the viscosity of the microemulsion phase of the microemulsion system. These more accurate values are based on the polymer partitioning. These more accurate viscosity values may in turn lead to more accurate simulations. The more accurate simulations may in turn lead to more accurate performance predictions. The more accurate performance predictions may lead to improved outcomes in chemical enhanced oil recovery processes, such as as the 2.7% improvement that may potentially result per the simulation (see FIG. 1F). Those of ordinary skill in the art will appreciate that these improvements may lead to more accurate chemical enhanced oil recovery process scenarios (during simulation) and improvements in controlling operations for a chemical enhanced oil recovery process in the subsurface reservoir process, including injecting an injection fluid with the polymer into an injection wellbore that is in fluidic communication with the subsurface reservoir, where the polymer has a concentration that was determined by the chemical enhanced oil recovery scenario. Those of ordinary skill in the art will appreciate that past simulators would assume polymer was equally allocated into the brine phase and the aqueous component of the microemulsion phase. On the other hand, the instant embodiments depart from this conventional assumption and perform polymer partitioning. For example, consistent with this disclosure, a simulator may receive values for $S_{1,C1}$ and $S_{1,C2}$ as input, which in turn may lead to more accurate simulations.

Advantageously, the embodiments provided herein may be utilized for forecasting a chemical enhanced oil recovery process.

Advantageously, the embodiments provided herein may be utilized for the following: The new polymer partitioning solution predicts the polymer partitioning coefficient in a smooth and continuous manner as a function of the excess brine saturation. The polymer partitioning solution can be used to accurately model experimental observations as shown in FIG. 5.

Advantageously, the embodiments provided herein may be utilized for the following: FIG. 6A, FIG. 6B, FIG. 6C, and FIG. 6D show calculations of polymer concentration in the excess brine phase and the water component in microemulsion phase using the polymer partitioning calculations from FIG. 5. The example calculations were done at four different total polymer concentrations.

Advantageously, the embodiments provided herein may be utilized for the following: FIG. 7A, FIG. 7B, FIG. 7C, and FIG. 7D show predictions of microemulsion phase viscosities using the polymer partitioning calculations from FIG. 5 and compare it to the state of the art. The example calculations were done at four different total polymer concentrations.

Advantageously, the embodiments provided herein may be utilized for the following: Allocating the polymer correctly in the phases is critical to determine the optimal amount of polymer required in chemical enhanced oil recovery processes which impacts overall project economics.

Advantageously, the embodiments provided herein may be utilized for the following: Prediction of correct viscosities is critical to obtain the right mobility of phases while designing for chemical enhanced oil recovery applications in the field. The mobility of phases directly impacts oil recovery and timing of oil production. Hence, the new method improves oil recovery forecasts/predictions.

Those of ordinary skill in the art will appreciate, for example, that the more accurate information may be utilized in hydrocarbon exploration and hydrocarbon production for decision making. For example, the more accurate information may be utilized to pick a location for a wellbore (e.g., infill wellbore). Those of ordinary skill in the art will appreciate that decisions about (a) where to drill one or more wellbores to produce hydrocarbons, (b) how many wellbores to drill to produce the hydrocarbons, etc. may be made based on the more accurate information. The more accurate information may even be utilized to select the trajectory of each wellbore to be drilled.

Those of ordinary skill in the art will appreciate, for example, that the more accurate information may be utilized in hydrocarbon exploration and hydrocarbon production for control. For example, the more accurate information may be utilized to steer a tool (e.g., drilling apparatus) to drill a wellbore. A drilling tool may be steered to drill one or more wellbores to produce the hydrocarbons or steered to avoid the hydrocarbons (e.g., avoid small hydrocarbon deposit) depending on the desired outcome. Steering the tool may include drilling around or avoiding certain subsurface features, drilling through certain subsurface features (e.g., hydrocarbon deposit), or any combination thereof depending on the desired outcome. As another example, the more accurate information may be utilized for controlling flow of fluids injected into or received from the subsurface, the wellbore, or any combination thereof. As another example, the more accurate information may be utilized for controlling flow of fluids injected into or received from at least one hydrocarbon producing zone of the subsurface. Chokes or well control devices, positioned on the surface or downhole, may be used to control the flow of fluid into and out. Thus, the more accurate information may be utilized to control injection rates, production rates, or any combination thereof.

Those of ordinary skill in the art will appreciate, for example, that the more accurate digital information may be utilized to select completions, components, fluids, etc. for a wellbore.

For simplicity, the many possibilities, including wellbore location, component selection for the wellbore, recovery technique selection, controlling flow of fluid, etc., may be collectively referred to as managing a subsurface reservoir.

**Computing System:** FIG. 2 illustrates one embodiment of a computing system 200 of determining partitioning of a polymer into phases of a microemulsion system in accordance with the disclosure. The computing system 200 includes a processor or processing unit 210 communicatively connected to a memory 212 via a data bus. The processor 210 may be any of a variety of types of programmable circuits capable of executing computer-readable instructions to perform various tasks, such as mathematical and communication tasks. The computing system 200 may comprise a computer, a phone, a tablet, a laptop, a wireless device, a wired device, a plurality of networked devices, etc.

The memory 212 may include any of a variety of memory devices, such as using various types of computer readable or computer storage media. A computer storage medium or computer readable medium may be any medium that can contain or store the program for use by or in connection with the instruction execution system, apparatus, or device. By way of example, computer storage media may include dynamic random access memory (DRAM) or variants thereof, solid state memory, read-only memory (ROM), electrically-erasable programmable ROM, optical discs (e.g., CD-ROMs, DVDs, etc.), magnetic disks (e.g., hard disks, floppy disks, etc.), magnetic tapes, and other types of devices and/or articles of manufacture that store data. Computer storage media generally includes at least one or more tangible media or devices. Computer storage media can, in some embodiments, include embodiments including entirely non-transitory components. In example embodiments, the computer storage medium is embodied as a computer storage device, such as a memory or mass storage device. In particular embodiments, the computer-readable media and computer storage media of the present disclosure comprise at least some tangible devices, and in specific embodiments such computer-readable media and computer storage media include exclusively non-transitory media.

The computing system 200 can also include a communication interface 206 configured to receive data such as from an experimental setup 204. The experimental setup 204 is configured to perform polymer partitioning/allocation experiments on an experimental microemulsion system and generate laboratory data. For example, the laboratory data may include an allocation of the polymer in each phase of the sample fluid based on physical laboratory experiments conducted on the sample fluid using physical laboratory equipment. Other data may also be received via the communication interface 206. The communication interface 206 may also be configured to transmit data, or other functionality. The computing system 200 is also configured to transmit notifications as generated by the data processing framework 214 and also includes a display 208 for presenting a user interface associated with the data processing framework 214. In various embodiments, the computing system 200 can include additional components, such as peripheral I/O devices, for example to allow a user to interact with the user interfaces generated by the data processing framework 214. In various embodiments, the computing system 200 may allow for interaction with at least one other software item, at least one other hardware item, or both (e.g., software or hardware items from third parties) to carry out one or more claim elements or other functionality.

The data processing framework 214 of the embodiment includes a phase behavior prediction module 216 that executes a method of predicting phase behavior. As depicted, the phase behavior prediction module 216 includes: (1) a module 218 for determining a number of phases in the microemulsion system and (2) a module 220 for polymer partitioning and microemulsion viscosity determination, and it may also include (3) a module for determining composition(s) of phase(s) in the microemulsion system.

Results may be generated during a simulation, and thus, this may represent a simulation component 250. Results may be utilized with an injection apparatus 222. The injection apparatus 222 may even be coupled to the computing system 200 in some embodiments.

Those of ordinary skill in the art will appreciate that various modifications may be made to the embodiments and the scope of the claims is not limited to the discussion herein. Indeed, embodiments of the present disclosure can be implemented as a system (e.g., an injection system, a computing system, a combination of an injection system and a computing system, etc.), a computer process (method), a process (method), a computing system or computer, as an article of manufacture (e.g., computer readable medium or computer storage medium an apparatus, a computer readable medium, a computer program product, a graphical user interface, a web portal, a data structure tangibly fixed in a computer readable memory, etc.

Turning to FIG. 3, this figure illustrates one embodiment of a method of determining partitioning of a polymer into phases of a microemulsion system, referred to as a method 300, in accordance with the disclosure. The method 300 may be executed by the computing system 200 of FIG. 2. Those of ordinary skill in the art will appreciate that various modifications may be made to the method 300, and the scope of the claims is not limited to the discussion herein. For example, those of ordinary skill in the art will appreciate that the inventive principles may be implemented using automated steps only in some embodiments, or using a combination of automated and manual steps in other embodiments. For ease of understanding, non-limiting examples will be used throughout the discussion of the method 300. Additional information is also available in US Patent App. Serial Nos. 62/557029 (Docket No. T-10508-P) and 62/561929 (T-10740-P) and US Patent App. Pub. Nos. 2019/0079066 (Docket No. T-10508) and 2019/0094199 (Docket No. T-10740), each of which is incorporated by reference in its entirety.

Optionally, the method 300 includes receiving laboratory data for a sample fluid comprising a polymer, an oil, a brine, and a surfactant. The sample fluid forms a microemulsion system. The laboratory data may include an allocation of the polymer in each phase of the sample fluid based on physical laboratory experiments conducted on the sample fluid using physical laboratory equipment. Some physical laboratory experiments that may be performed on the sample fluid are described in Tagavifar, M., Herath, S., Weerasooriya, U. P., Sepehrnoori, K., & Pope, G. (2016, April). Measurement of microemulsion viscosity and its implications for chemical EOR. In SPE Improved Oil Recovery Conference. Society of Petroleum Engineers. This reference is incorporated by reference in its entirety. The laboratory data may be received by the communication interface 206 from the experimental setup 204 (e.g., from a computing system of the experimental setup 204), from a third party (e.g., from a computing system of the third party), etc. Alternatively, the laboratory data may be received as input via user input.

At 310, the method 300 includes generating a polymer partitioning model. In one embodiment, the polymer partitioning model is generated based on the laboratory data, for example, the polymer partitioning model is generated based on the laboratory data for the sample fluid that forms the microemulsion system and comprises the polymer, the oil, the brine, and the surfactant. The polymer partitioning model determines a concentration of the polymer in a brine phase of the microemulsion system and a concentration of the polymer in an aqueous component of a microemulsion phase of the microemulsion system. As will be discussed hereinbelow, $S_{1,C1}$ and $S_{1,C2}$ are model parameters in the polymer partitioning model. The processor 210 may perform this portion at 310 using at least one of the following equations discussed hereinbelow.

In terms of a simulation, this portion at 310 may be performed at each timestep for each cell. For example, the simulation may be performed by a simulation component, such as the simulation component 250, which may include one or more features of a simulator such as the ECLIPSE™ reservoir simulator (Schlumberger Limited, Houston Texas), the INTERSECT™ reservoir simulator (Schlumberger Limited, Houston Texas), etc. Simulation is discussed further in the following: Delshad, M., Pope, G. A., & Sepehrnoori, K. (2015). Volume II: Technical Documentation for UTCHEM 2015, A Three-Dimensional Chemical Flood Simulator. Technical Documentation. Center for Petroleum and Geosystems Engineering, The University of Texas at Austin, Austin, Texas. Simulation is also discussed in the following: Najafabadi, N.F. and Chawathe, A. (2016): Proper Simulation of Chemical EOR (CEOR) Pilots - A Real Case Study. SPE-179659-MS. In SPE Improved Oil Recovery Conference, Society of Petroleum Engineers. Each of these references is incorporated by reference herein

Partitioning the polymer includes using a partitioning coefficient (K). The partitioning coefficient (K) is determined using an equation, the equation comprising:

$$K = \frac{C_{13}^4}{C_1^4} = \frac{C_1 C_{13}^4}{C_4} \quad (1)$$

wherein $C_{13}^4$ is the concentration of the polymer in the aqueous component of the microemulsion phase, $C_1^4$ represents a concentration of the polymer in a total aqueous component of the microemulsion system, $C_1$ represents total aqueous volume concentration of the microemulsion system, and $C_4$ represents total mass concentration of the polymer in the microemulsion system.

The partitioning coefficient (K) is defined as a function of brine phase saturation ($S_1$) according to equations comprising:

$$K(S_1) = 1 \quad \text{for} \quad 0 < S_1 < S_{1,C1} \quad (2)$$

$$K(S_1) = 1 - 3\left[\frac{S_1 - S_{1,C1}}{S_{1,C2} - S_{1,C1}}\right]^2 + 2\left[\frac{S_1 - S_{1,C1}}{S_{1,C2} - S_{1,C1}}\right]^3 \quad \text{for} \quad S_{1,C1} \le S_1 \le S_{1,C2} \ \text{and} \tag{3}$$

$$K(S_1) = 0 \quad \text{for} \quad S_{1,C2} < S_1 \le 1 \tag{4}$$

wherein $S_{1,C1}$ is represents critical brine phase saturation after which the polymer preferentially partitions into the brine phase, and $S_{1,C2}$ represents critical brine phase saturation beyond which the polymer is entirely contained in the brine phase. The equations (2), (3), and (4) are modelled using a cubic smooth-step function. The equations (2), (3), and (4) are continuous at the two critical brine saturations of $S_{1,C1}$ and $S_{1,C2}$.

In other words, the polymer partitioning between the brine phase and the aqueous component of the microemulsion phase is modeled using a cubic smooth-step function. The mathematical function used is continuous over the range of possible physical values of brine phase saturation (0 to 1). Hence, the polymer is considered a pseudocomponent that partitions across phases and affects phase viscosity. However, the traditional assumption that the polymer does not affect phase behavior was maintained, discussed further in Pope, G. A., Tsaur, K., Schechter, R. S., & Wang, B. (1982). The effect of several polymers on the phase behavior of micellar fluids. Society of Petroleum Engineers Journal, 22(06), 816-830, which is incorporated by reference herein.

FIG. 4 illustrates an example of a polymer partitioning coefficient as a function of brine phase saturation. The critical brine phase saturations in FIG. 4 are $S_{1,C1}$ = 0.2 and $S_{1,C2}$ = 0.6. In some embodiments, $S_{1,C1}$ and $S_{1,C2}$ are user defined model inputs that are obtained from fitting experimental data, for example, as illustrated in FIG. 5. FIG. 5 illustrates another example of the polymer partitioning coefficient as a function of brine phase saturation. The critical brine phase saturations in FIG. 5 are $S_{1,C1}$ = 0.43 and $S_{1,C2}$ = 0.65.

The concentration of the polymer in the brine phase is determined using an equation, the equation comprising:

$$C_{41} = \frac{C_4(C_1 - KS_3C_{13})}{C_1S_1} \tag{5}$$

wherein $C_{41}$ represents the concentration of the polymer in the brine phase of the microemulsion system. The concentration of the polymer in the aqueous component of the microemulsion phase of the microemulsion system is determined using an equation, the equation comprising:

$$C_{13}^4 = K\frac{C_4}{C_1} \tag{6}$$

wherein $C_{13}^4$ represents the concentration of the polymer in the aqueous component of the microemulsion phase of the microemulsion system.

FIGS. 6A-6D illustrate examples of concentrations of the polymer in the brine phase and concentrations of the polymer in the aqueous component of the microemulsion phase that may be calculated using the polymer partitioning coefficient of FIG. 5. FIGS. 6A-6D also illustrate comparisons of these calculated concentrations of the polymer against the state of the art. As illustrated, those of ordinary skill in the art will appreciate that partitioning the polymer into the different phases of the microemulsion system as described herein leads to calculated concentrations of the polymer that are more accurate than those calculated using conventional techniques in the state of the art. For instance, each of these figures illustrates that the concentration of the polymer in the brine phase is higher than indicated by conventional techniques in the state of the art, while the concentration of the polymer in the aqueous component of the microemulsion phase is lower than indicated by conventional techniques in the state of the art.

Some assumptions may be implemented during polymer partitioning. For example, if a microemulsion phase exists in a microemulsion system but a brine phase is absent in that microemulsion system, then all of the polymer may be allocated to the aqueous component of the microemulsion phase. This is a physical assumption as polymer does not partition into an oil phase and the brine phase is absent. As another example, if a brine phase exists in a microemulsion system, the polymer partitions increasingly into the brine phase as its saturation increases. This assumption prevents drastic changes in polymer concentrations in phases across different phase behavior regimes. Indeed, a critical brine saturation exists for a microemulsion system after which, all of the polymer will be contained entirely in the brine phase. This physical parameter can be tuned to match microemulsion viscosity data from laboratory experiments.

At 315, the method includes determining a viscosity of the brine phase of the microemulsion system using the concentration of the polymer in the brine phase of the microemulsion system, determining a viscosity of the aqueous component of the microemulsion phase of the microemulsion system using the concentration of the polymer in the aqueous component of the microemulsion phase of the microemulsion system, and determining a viscosity of the microemulsion phase of the microemulsion system using the viscosity of the aqueous component of the microemulsion phase of the microemulsion system. The processor 210 may perform this portion using at least one of the following equations discussed hereinbelow. In terms of a simulation, this portion at 315 may be performed at each timestep for each cell by the simulation component 250.

A polymer viscosity model may be used to calculate the viscosity of the brine phase from $C_{41}$ and calculate the viscosity of the aqueous component of the microemulsion phase from $C_{13}^4$. The polymer viscosity model comprises: (A) the Flory-Huggins equation to calculate the viscosity as a function of polymer and salinity as illustrated in the UTCHEM technical documentation, and (B) Meter's equation to correct the viscosity calculated by the Flory-Huggins equation at a shear rate of interest. The Flory-Huggins equation is discussed in Flory, P.J. 1953. Principles of Polymer Chemistry, Ithaca, New York. Cornell University Press. The UTCHEM is discussed in Delshad, M., Pope, G. A., & Sepehrnoori, K. (2015). Volume II: Technical Documentation for UTCHEM 2015, A Three-Dimensional Chemical Flood Simulator. Technical Documentation. Center for Petroleum and Geosystems Engineering, The University of Texas at Austin, Austin, Texas. The Meter's equation is discussed in Meter, D.M. and Bird, R.B. 1964. "Tube Flow of Non-Newtonian Polymer Solutions, Parts I and II Laminar Flow and Rheological Models," AIChE J., 878-881, 1143-1150. Each of these references is incorporated by reference herein.

The viscosity of the microemulsion phase of the microemulsion system may be determined using the viscosity of the aqueous component of the microemulsion phase of the microemulsion system via a modified version of the microemulsion viscosity model that was described in Tagavifar, M., Herath, S., Weerasooriya, U. P., Sepehrnoori, K., & Pope, G. (2016, April). Measurement of microemulsion viscosity and its implications for chemical EOR. SPE-179659-MS. In SPE Improved Oil Recovery Conference. Society of Petroleum Engineers, which is incorporated by reference herein. The modification is the inclusion of the viscosity of the polymer concentration in the aqueous component in the microemulsion phase. This modified version includes 8 tuning parameters. Two tuning parameters are obtained by fitting the model to microemulsion viscosity data at low shear rates. Two parameters are used to describe the viscosity at infinite shear rate and two parameters are used to describe the viscosity as a function of shear rate in intermediate shear rates. One parameter is used to model the impact of co-solvent on viscosity of the microemulsion phase.

Viscosity of the microemulsion phase at low shear rate - The viscosity of the microemulsion phase at low shear rate is defined via an equation, the equation comprising:

$$\mu_{me,0} = \left[\frac{1 - C_{23}}{\mu_p \exp(\alpha_2 C_{23})} + \frac{C_{23}}{\mu_o \exp(\alpha_1 (1 - C_{23}))}\right]^{-1} \quad (7)$$

wherein $\mu_p$ is the polymer viscosity of the aqueous component in the microemulsion phase. $\mu_p$ in Eq. (7) is obtained from the polymer viscosity model by calculating the viscosity at polymer concentration of $C_{13}^4$ using the polymer viscosity model described hereinabove. Constants $\alpha_1$ and $\alpha_2$ in Eq. (7) are model input parameters that determine the water contribution and oil contribution, respectively, to viscosity of the microemulsion phase at low shear rate.

Viscosity of the microemulsion phase at infinite shear rate - In order to calculate the viscosity of the microemulsion phase at infinite shear rate, $f_o$ and $f_1$ are calculated using the following equations:

$$f_0 = (1 - C_{23} + {C_{23}}^2)^{\alpha_3} \quad (8)$$

$$f_1 = \alpha_4((C_{23} - {C_{23}}^2)[0.1 + (C_{23} - \alpha_5)(1 - C_{23} - \alpha_5)])^2 \quad (9)$$

From Eqns. (8) and (9), viscosity of the microemulsion phase at infinite shear rate is determined using an equation, the equation comprising:

$$\mu_{me,\infty} = (C_{23}\mu_o + (1 - C_{23})\mu_p) \times (f_0 + f_1) \quad (10)$$

Hence, $\alpha_3$, $\alpha_4$ and $\alpha_5$ in Eqns. (8) and (9) are model parameters that determine microemulsion phase viscosity behavior at high shear rates. Polymer viscosity $\mu_p$ in Eq. (7) is obtained from the polymer viscosity model by calculating the viscosity at polymer concentration of $C_{13}^4$ as calculated from Eq. (6).

Microemulsion phase velocity at a given shear rate - After calculating $\mu_{me,0}$ and $\mu_{me,\infty}$ from Eqns. (7) and (10) respectively, the microemulsion viscosity at a shear rate of y is determined using an equation, the equation comprising:

$$\mu_{me,\gamma} = \frac{(\mu_{me,0} - \mu_{me,\infty})}{1 + \left[\frac{\gamma}{\alpha_6(1+\alpha_8 C_{cs})}\right]^{\alpha_7 - 1}} + \mu_{me,\infty} \quad (11)$$

wherein $\alpha_6$, $\alpha_7$ and $\alpha_8$ are user defined model constants (inputs) and $C_{cs}$ represents the co-solvent concentration in the total aqueous component in the microemulsion system. Parameter $\alpha_7$ determines the value of the exponent in shear thinning behavior while $\alpha_6$ is the shear rate after which shear thinning (non-Newtonian) behavior is prominent. $\alpha_8$ captures the effect of co-solvent on viscosity of the microemulsion phase.

FIGS. 7A-7D illustrate examples of viscosities of the microemulsion phase that were calculated based on the polymer partitioning of FIG. 5. FIGS. 7A-7D also illustrate comparisons of the calculated viscosities against the state of the art. As illustrated, those of ordinary skill in the art will appreciate that the viscosity of each microemulsion phase is lower than indicated by conventional techniques in the state of the art.

At 320, the method includes using the viscosity of the brine phase of the microemulsion system and the viscosity of the microemulsion phase of the microemulsion system to determine performance of a chemical enhanced oil recovery process scenario where the polymer is injected into a subsurface reservoir. In terms of a simulation, this portion at 320 may be performed at each timestep for each cell by the simulation component 250.

For example, determining performance may include determining different concentrations of the polymer and determining the performance of the chemical enhanced oil recovery process with each concentration of the polymer. As another example, determining performance includes determining an optimal or close to optimal concentration of the polymer that should be used in the injection fluid in the chemical enhanced oil recovery process, which impacts overall project economics. As another example, determining performance may include forecasting incremental oil recovery. As another example, determining performance may include whether or not to convert a wellbore into an injection wellbore or simply shut-in the wellbore. As another example, determining performance may be based on more accurate simulations, and for example, the simulation may be utilized to determine how to control injection wellbore(s) and production wellbore(s), including adjusting the pressure, concentration of the polymer, injection flow rate, cumulative amount of injection fluid, etc. See FIGS. 1E-1F.

Various scenarios may be generated at 320, and performance may be determined and decisions that may be taken based on a selected scenario. For example, a plurality of chemical enhanced oil recovery scenarios are generated and operations of a chemical enhanced oil recovery process in the subsurface reservoir may be carried out based on a chemical enhanced oil recovery scenario selected from the plurality of chemical enhanced oil recovery scenarios.

For example, the chemical enhanced oil recovery scenario may be utilized to physically control operations for a chemical enhanced oil recovery process in the subsurface reservoir in a real field. Controlling operations for the chemical enhanced oil recovery process in the subsurface reservoir includes injecting an injection fluid with the polymer into an injection wellbore that is in fluidic communication with the subsurface reservoir, wherein the polymer that is injected has a concentration that was determined by the chemical enhanced oil recovery scenario. The injection fluid with the polymer is injected into the injection wellbore with an injection apparatus, such as the injection apparatus 222.

FIG. 8 schematically illustrates an example of a multilayered subsurface reservoir 20. Reservoir 20 can be any type of subsurface reservoir in which hydrocarbons are stored, such as limestone, dolomite, oil shale, sandstone, or any combination thereof. As illustrated in FIG. 8, production wellbores 30, 34 and injection wellbore 32 are drilled and completed in reservoir 20. Production or injection wellbores can deviate from the vertical position such that in some embodiments, one or more wellbores can be a directional wellbore, horizontal wellbore, or a multilateral wellbore. In embodiments, fewer or additional injection wellbores and/or production wellbores can also extend into hydrocarbon bearing zones 22, 24 of reservoir 20. Reservoir 20 includes a plurality of rock layers including hydrocarbon bearing strata or zones 22, 24. In embodiments, the reservoir 20 may include more zones than those illustrated in FIG. 8. Production wellbores 30, 34 and injection wellbore 32 extend into one or more of the plurality of rock layers (e.g., hydrocarbon bearing strata or zones 22, 24) of reservoir 20 such that the production wellbores 30, 34 and injection wellbore 32 are in fluid communication with hydrocarbon bearing zones 22, 24. For example, production wellbores 30, 34 can receive fluids (e.g., gas, oil, water) from hydrocarbon bearing zones 22, 24 and injection wellbore 32 can inject fluid into hydrocarbon bearing zones 22, 24. Accordingly, production wellbores 30, 34 and injection wellbore 32 fluidly connect hydrocarbon bearing zones 22, 24 to surface 40 of reservoir 20. Surface 40 of reservoir 20 can be a ground surface as depicted in FIG. 8 or a platform surface in an offshore environment.

As one skilled in the art will recognize, production or injection wellbores can be completed in any manner (e.g., an openhole completion, a cemented casing and/or liner completion, a gravel-packed completion, etc.). As shown in FIG. 8, completions 42, 44, 46, 50, 52 provide fluid communication between injection wellbore 32, hydrocarbon bearing zones 22, 24, and production wellbores 30, 34. Production wellbore 34 only connects with upper hydrocarbon bearing zone 22. Chokes or well control devices 54, 56, 60 are used to control the flow of fluid into and out of respective production wellbores 30, 34 and injection wellbore 32. Well control devices 54, 56, 60 also control the pressure profiles in production wellbores 30, 34 and injection wellbore 32. Although not shown, production wellbores 30, 34 and injection wellbore 32 fluidly connect with surface facilities (e.g., oil/gas/water separators, gas compressors, storage tanks, pumps, gauges, pipelines). The rate of flow of fluids through production wellbores 30, 34 and injection wellbore 32 may be limited by the fluid handling capacities of the surface facilities. Furthermore, while control devices 54, 56, 60 are shown above surface in FIG. 8, control devices can also be positioned downhole to control the flow of fluids injected into or received from each of hydrocarbon bearing zones 22, 24.

Returning to 320 in FIG. 3, a user may select at least one of the scenarios generated at 320 to design the polymer. Designing the polymer includes using the selected scenario to create a particular polymer based on the concentration of the polymer indicated in the selected scenario, which may include a mixing step as in the case of a powder polymer. Furthermore, as in FIG. 8, the user may cause the particular polymer to be added to an injection fluid and may cause the injection fluid to be injected into the injection wellbore 32 using an injection apparatus 222 (FIG. 2) in order to perform chemical enhanced oil recovery process in the subsurface reservoir 20 proximate to the injection wellbore 32. As discussed hereinabove, the injection apparatus 222 may include a tank, a mixer, a wellhead, a pump, or any other equipment for mixing and/or injecting. The injection fluid sweeps hydrocarbons in the reservoir 20 towards the production wellbores 30, 34 and up towards the surface 40 to the surface facilities. The wellbores in FIG. 8 may be pre-existing or new (e.g., infill wellbores). All of the benefits discussed herein of polymer partitioning may be applied to FIG. 8.

Referring in particular to computing systems embodying the methods and systems of the present disclosure, it is noted that various computing systems can be used to perform the processes disclosed herein. For example, embodiments of the disclosure may be practiced in various types of electrical circuits comprising discrete electronic elements, packaged or integrated electronic chips containing logic gates, a circuit utilizing a microprocessor, or on a single chip containing electronic elements or microprocessors. Embodiments of the disclosure may also be practiced using other technologies capable of performing logical operations such as, for example, AND, OR, and NOT, including but not limited to mechanical, optical, fluidic, and quantum technologies. In addition, aspects of the methods described herein can be practiced within a general purpose computer or in any other circuits or systems.

Embodiments of the present disclosure can be implemented as a computer process (method), a computing system, or as an article of manufacture, such as a computer program product or computer readable media. The term computer readable media as used herein may include computer storage media. Computer storage media may include volatile and nonvolatile, removable and non-removable media implemented in any method or technology for storage of information, such as computer readable instructions, data structures, or program modules. Computer storage media may include RAM, ROM, electrically erasable read-only memory (EEPROM), flash memory or other memory technology, CD-ROM, digital versatile disks (DVD) or other optical storage, magnetic cassettes, magnetic tape, magnetic disk storage or other magnetic storage devices, or any other article of manufacture which can be used to store information and which can be accessed by the computing system 400, above. Computer storage media does not include a carrier wave or other propagated or modulated data signal. In some embodiments, the computer storage media includes at least some tangible features; in many embodiments, the computer storage media includes entirely non-transitory components.

The description and illustration of embodiments provided in this application are not intended to limit or restrict the scope of the invention as claimed in any way. The embodiments, examples, and details provided in this application are considered sufficient to convey possession and enable others to make and use the best mode of claimed invention. The claimed invention should not be construed as being limited to any embodiment, example, or detail provided in this application. Regardless whether shown and described in combination or separately, the various features (both structural and methodological) are intended to be selectively included or omitted to produce an embodiment with a particular set of features. Having been provided with the description and illustration of the present application, one skilled in the art may envision variations, modifications, and alternate embodiments falling within the spirit of the broader aspects of the claimed invention and the general inventive concept embodied in this application that do not depart from the broader scope.

One skilled in the art will recognize that the various components or technologies may provide certain necessary or beneficial functionality or features. Accordingly, these functions and features as may be needed in support of the appended claims and variations thereof, are recognized as being inherently included as a part of the teachings herein and a part of the invention disclosed.

Moreover, while the invention has been described with reference to various embodiments, it will be understood by those skilled in the art that various changes may be made and equivalents may be substituted for elements thereof without departing from the scope of the invention. In addition, many modifications will be appreciated by those skilled in the art to adapt a particular instrument, situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims. It is to be expressly understood, however, that each of the figures is provided for the purpose of illustration and description only and is not intended to limit the present invention.

In any of the above aspects, the various features may be implemented in hardware, or as software modules running on one or more processors. Features of one aspect may be applied to any of the other aspects.

The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

The present disclosure extends to the following statements:

S1. A computer implemented method of determining partitioning of a polymer into phases of a microemulsion system, the method comprising:

(a) generating a polymer partitioning model, wherein the polymer partitioning model determines a concentration of the polymer in a brine phase of the microemulsion system and a concentration of the polymer in an aqueous component of a microemulsion phase of the microemulsion system;
(b) determining a viscosity of the brine phase of the microemulsion system using the concentration of the polymer in the brine phase of the microemulsion system, determining a viscosity of the aqueous component of the microemulsion phase of the microemulsion system using the concentration of the polymer in the aqueous component of the microemulsion phase of the microemulsion system, and determining a viscosity of the microemulsion phase of the microemulsion system using the viscosity of the aqueous component of the microemulsion phase of the microemulsion system; and
(c) using the viscosity of the brine phase of the microemulsion system and the viscosity of the microemulsion phase of the microemulsion system to determine performance of a chemical enhanced oil recovery process scenario where the polymer is injected into a subsurface reservoir.

S2. The method of statement S1, wherein generating the polymer partitioning model includes using a partitioning coefficient (K), wherein the partitioning coefficient (K) is determined using an equation, the equation comprising:

$$K = \frac{C_{13}^{4}}{C_{1}^{4}} = \frac{C_1 C_{13}^{4}}{C_4} \quad (1)$$

wherein $C_{13}^{4}$ is the concentration of the polymer in the aqueous component of the microemulsion phase, $C_{1}^{4}$ represents a concentration of the polymer in a total aqueous component of the microemulsion system, $C_1$ represents a total aqueous volume concentration of the microemulsion system, and $C_4$ represents a total mass concentration of the polymer in the microemulsion system.

S3. The method of statement S2, wherein the partitioning coefficient (K) is defined as a function of brine phase saturation ($S_1$) according to equations comprising:

$$K(S_1) = 1 \quad \text{for} \quad 0 < S_1 < S_{1,C1} \quad (2)$$

$$K(S_1) = 1 - 3\left[\frac{S_1 - S_{1,C1}}{S_{1,C2} - S_{1,C1}}\right]^2 + 2\left[\frac{S_1 - S_{1,C1}}{S_{1,C2} - S_{1,C1}}\right]^3 \quad \text{for} \quad S_{1,C1} \leq S_1 \leq S_{1,C2} \text{ and,} \tag{3}$$

$$K(S_1) = 0 \quad \text{for} \quad S_{1,C2} < S_1 \leq 1 \tag{4}$$

wherein $S_{1,C1}$ represents a critical brine saturation after which the polymer preferentially partitions into the brine phase, $S_{1,C2}$ represents a critical brine saturation beyond which the polymer is entirely contained in the brine phase.

S4. The method of statement S3, wherein $S_{1,C1}$ and $S_{1,C2}$ are parameters in the polymer partitioning model.

S5. The method of statement S3, wherein the equations (2), (3) and (4) are continuous at the two critical brine saturations of $S_{1,C1}$ and $S_{1,C2}$.

S6. The method of statement S3, wherein the equations (2), (3) and (4) are modelled using a cubic smooth-step function.

S7. The method of statement S3, wherein the concentration of the polymer in the brine phase is determined using an equation, the equation comprising:

$$C_{41} = \frac{C_4(C_1 - KS_3C_{13})}{C_1S_1} \tag{5}$$

wherein $C_{41}$ represents the concentration of the polymer in the brine phase of the microemulsion system.

S8. The method of statement S3, wherein the concentration of the polymer in the aqueous component of the microemulsion phase of the microemulsion system is determined using an equation, the equation comprising:

$$C_{13}^4 = K\frac{C_4}{C_1} \tag{6}$$

wherein $C_{13}^4$ represents the concentration of the polymer in the aqueous component of the microemulsion phase of the microemulsion system.

S9. The method of statement S1, wherein (a), (b), (c), or any combination thereof is calculated at every timestep for each cell during a simulation.

S10. The method of statement S1, wherein a plurality of chemical enhanced oil recovery scenarios are generated, and wherein operations of a chemical enhanced oil recovery process in the subsurface reservoir are carried out based on a chemical enhanced oil recovery scenario from the plurality of chemical enhanced oil recovery scenarios.

S11. The method of statement S1, wherein determining the viscosity of the brine phase includes using a polymer viscosity model with the concentration of the polymer in the brine phase as an input into Flory-Huggins and Meter equations.

S12. The method of statement S1, wherein determining the viscosity of the aqueous component of the microemulsion phase includes using the concentration of the polymer in the aqueous component of the microemulsion phase as input into Flory-Huggins and Meter equations.

S13. The method of statement S1, wherein determining the viscosity of the microemulsion phase includes using a microemulsion viscosity model corrected for polymer partitioning.

S14. The method of statement S1, wherein determining performance of the chemical enhanced oil recovery process scenario comprises forecasting incremental oil recovery.

S15. The method of statement S1, wherein the polymer partitioning model is generated based on laboratory data for a sample fluid that forms the microemulsion system and comprises the polymer, an oil, a brine, and a surfactant.

S16. The method of statement S1, wherein the chemical enhanced oil recovery scenario is utilized to control operations for a chemical enhanced oil recovery process in the subsurface reservoir.

S17. The method of statement S16, wherein controlling operations for the chemical enhanced oil recovery process in the subsurface reservoir includes injecting an injection fluid with the polymer into an injection wellbore that is in fluidic communication with the subsurface reservoir, wherein the polymer that is injected has a concentration that was determined by the chemical enhanced oil recovery scenario.

S18. The method of statement S17, wherein the injection fluid with the polymer is injected into the injection wellbore with an injection apparatus.

S 19. A system comprising:

a processor; and
a memory operatively connected to the processor, the memory storing instructions that, when executed by the processor, cause the system to perform a method of determining partitioning of a polymer into phases of a microemulsion system, the method comprising:

(a) generating a polymer partitioning model, wherein the polymer partitioning model determines a concentration of the polymer in a brine phase of the microemulsion system and a concentration of the polymer in an aqueous component of a microemulsion phase of the microemulsion system;
(b) determining a viscosity of the brine phase of the microemulsion system using the concentration of the polymer in the brine phase of the microemulsion system, determining a viscosity of the aqueous component of the microemulsion phase of the microemulsion system using the concentration of the polymer in the aqueous component of the microemulsion phase of the microemulsion system, and determining viscosity of the microemulsion phase of the microemulsion system using the viscosity of the aqueous component of the microemulsion phase of the microemulsion system; and
(c) using the viscosity of the brine phase of the microemulsion system and the viscosity of the microemulsion phase of the microemulsion system to determine performance of a chemical enhanced oil recovery process scenario where the polymer is injected into a subsurface reservoir.

S20. The system of statement S 19, wherein generating the polymer partitioning model includes using a partitioning coefficient (K), wherein the partitioning coefficient (K) is determined using an equation, the equation comprising:

$$K = \frac{C_{13}^4}{C_1^4} = \frac{C_1 C_{13}^4}{C_4} \quad (1)$$

wherein $C_{13}^4$ is the concentration of the polymer in the aqueous component of the microemulsion phase, $C_1^4$ represents a concentration of the polymer in a total aqueous component of the microemulsion system, $C_1$ represents a total aqueous volume concentration of the microemulsion system, and $C_4$ represents a total mass concentration of the polymer in the microemulsion system.

S21. The system of statement S20, wherein the partitioning coefficient (K) is defined as a function of brine phase saturation ($S_1$) according to equations comprising:

$$K(S_1) = 1 \quad \text{for} \quad 0 < S_1 < S_{1,C1} \tag{2}$$

$$K(S_1) = 1 - 3\left[\frac{S_1 - S_{1,C1}}{S_{1,C2} - S_{1,C1}}\right]^2 + 2\left[\frac{S_1 - S_{1,C1}}{S_{1,C2} - S_{1,C1}}\right]^3 \quad \text{for} \quad S_{1,C1} \leq S_1 \leq S_{1,C2} \ \text{and,} \tag{3}$$

$$K(S_1) = 0 \quad \text{for} \quad S_{1,C2} < S_1 \leq 1 \tag{4}$$

wherein $S_{1,C1}$ represents a critical brine saturation after which the polymer preferentially partitions into the brine phase, $S_{1,C2}$ represents a critical brine saturation beyond which the polymer is entirely contained in the brine phase.

S22. The system of statement S21, wherein $S_{1,C1}$ and $S_{1,C2}$ are parameters in the polymer partitioning model.

S23. The system of statement S21, wherein the equations (2), (3) and (4) are continuous at the two critical brine saturations of $S_{1,C1}$ and $S_{1,C2}$.

S24. The system of statement S21, wherein the equations (2), (3) and (4) are modelled using a cubic smooth-step function.

S25. The system of statement S21, wherein the concentration of the polymer in the brine phase is determined using an equation, the equation comprising:

$$C_{41} = \frac{C_4(C_1 - KS_3C_{13})}{C_1S_1} \tag{5}$$

wherein $C_{41}$ represents the concentration of the polymer in the brine phase of the microemulsion system.

S26. The system of statement S21, wherein the concentration of the polymer in the aqueous component of the microemulsion phase of the microemulsion system is determined using an equation, the equation comprising:

$$C_{13}^4 = K\frac{C_4}{C_1} \tag{6}$$

wherein $C_{13}^4$ represents the concentration of the polymer in the aqueous component of the microemulsion phase of the microemulsion system.

S27. The system of statement S19, wherein (a), (b), (c), or any combination thereof is calculated at every timestep for each cell during a simulation.

S28. The system of statement S19, wherein a plurality of chemical enhanced oil recovery scenarios are generated, and wherein operations of a chemical enhanced oil recovery process in the subsurface reservoir are carried out based on a chemical enhanced oil recovery scenario from the plurality of chemical enhanced oil recovery scenarios

S29. The system of statement S19, wherein determining the viscosity of the brine phase includes using a polymer viscosity model with the concentration of the polymer in the brine phase as an input into Flory-Huggins and Meter equations.

S30. The system of statement S19, wherein determining the viscosity of the aqueous component of the microemulsion phase includes using the concentration of the polymer in the aqueous component of the microemulsion phase as input into Flory-Huggins and Meter equations.

S31. The system of statement S19, wherein determining the viscosity of the microemulsion phase includes using a microemulsion viscosity model corrected for polymer partitioning.

S32. The system of statement S19, wherein determining performance of the chemical enhanced oil recovery process scenario comprises forecasting incremental oil recovery.

S33. The system of statement S19, wherein the polymer partitioning model is generated based on laboratory data for a sample fluid that forms the microemulsion system and comprises the polymer, an oil, a brine, and a surfactant.

S34. The system of statement S19, wherein the chemical enhanced oil recovery scenario is utilized to control operations for a chemical enhanced oil recovery process in the subsurface reservoir.

S35. The system of statement S34, wherein controlling operations for the chemical enhanced oil recovery process in the subsurface reservoir includes injecting an injection fluid with the polymer into an injection wellbore that is in fluidic communication with the subsurface reservoir, wherein the polymer that is injected has a concentration that was determined by the chemical enhanced oil recovery scenario.

S36. The system of statement S35, wherein the injection fluid with the polymer is injected into the injection wellbore with an injection apparatus.

S37. The system of statement S35, wherein the injection wellbore is in fluidic communication with a production wellbore such that the injection fluid with the polymer sweeps hydrocarbons in the subsurface reservoir towards the production wellbore.

S38. A non-transitory computer-readable medium storing instructions that, when executed by a computer, cause the computer to perform a method of determining partitioning of a polymer into phases of a microemulsion system, the method comprising:

(a) generating a polymer partitioning model, wherein the polymer partitioning model determines a concentration of the polymer in a brine phase of the microemulsion system and a concentration of the polymer in an aqueous component of a microemulsion phase of the microemulsion system;
(b) determining a viscosity of the brine phase of the microemulsion system using the concentration of the polymer in the brine phase of the microemulsion system, determining a viscosity of the aqueous component of the microemulsion phase of the microemulsion system using the concentration of the polymer in the aqueous component of the microemulsion phase of the microemulsion system, and determining a viscosity of the microemulsion phase of the microemulsion system using the viscosity of the aqueous component of the microemulsion phase of the microemulsion system; and
(c) using the viscosity of the brine phase of the microemulsion system and the viscosity of the microemulsion phase of the microemulsion system to determine performance of a chemical enhanced oil recovery process scenario where the polymer is injected into a subsurface reservoir.

## Claims

**1.** A computer implemented method of determining partitioning of a polymer into phases of a microemulsion system, the method comprising:

(a) generating a polymer partitioning model, wherein the polymer partitioning model determines a concentration of the polymer in a brine phase of the microemulsion system and a concentration of the polymer in an aqueous component of a microemulsion phase of the microemulsion system;
(b) determining a viscosity of the brine phase of the microemulsion system using the concentration of the polymer in the brine phase of the microemulsion system, determining a viscosity of the aqueous component of the microemulsion phase of the microemulsion system using the concentration of the polymer in the aqueous component of the microemulsion phase of the microemulsion system, and determining a viscosity of the microemulsion phase of the microemulsion system using the viscosity of the aqueous component of the microemulsion phase of the microemulsion system; and

(c) using the viscosity of the brine phase of the microemulsion system and the viscosity of the microemulsion phase of the microemulsion system to determine performance of a chemical enhanced oil recovery process scenario where the polymer is injected into a subsurface reservoir.

**2.** The method of claim 1, wherein generating the polymer partitioning model includes using a partitioning coefficient (K), wherein the partitioning coefficient (K) is determined using an equation, the equation comprising:

$$K = \frac{C_{13}^4}{C_1^4} = \frac{C_1 C_{13}^4}{C_4} \qquad (1)$$

wherein $C_{13}^4$ is the concentration of the polymer in the aqueous component of the microemulsion phase, $C_1^4$ represents a concentration of the polymer in a total aqueous component of the microemulsion system, $C_1$ represents a total aqueous volume concentration of the microemulsion system, and $C_4$ represents a total mass concentration of the polymer in the microemulsion system.

**3.** The method of claim 2, wherein the partitioning coefficient (K) is defined as a function of brine phase saturation ($S_1$) according to equations comprising:

$$K(S_1) = 1 \quad \text{for} \quad 0 < S_1 < S_{1,C1} \qquad (2)$$

$$K(S_1) = 1 - 3\left[\frac{S_1 - S_{1,C1}}{S_{1,C2} - S_{1,C1}}\right]^2 + 2\left[\frac{S_1 - S_{1,C1}}{S_{1,C2} - S_{1,C1}}\right]^3 \quad \text{for} \quad S_{1,C1} \le S_1 \le S_{1,C2} \ \text{and,} \qquad (3)$$

$$K(S_1) = 0 \quad \text{for} \quad S_{1,C2} < S_1 \le 1 \qquad (4)$$

wherein $S_{1,C1}$ represents a critical brine saturation after which the polymer preferentially partitions into the brine phase, $S_{1,C2}$ represents a critical brine saturation beyond which the polymer is entirely contained in the brine phase.

**4.** The method of claim 3, wherein:

$S_{1,C1}$ and $S_{1,C2}$ are parameters in the polymer partitioning model; and/or
the equations (2), (3) and (4) are continuous at the two critical brine saturations of $S_{1,C1}$ and $S_{1,C2}$; and/or
the equations (2), (3) and (4) are modelled using a cubic smooth-step function.

**5.** The method of claim 3 or 4, wherein the concentration of the polymer in the brine phase is determined using an equation, the equation comprising:

$$C_{41} = \frac{C_4 (C_1 - K S_3 C_{13})}{C_1 S_1} \qquad (5)$$

wherein $C_{41}$ represents the concentration of the polymer in the brine phase of the microemulsion system.

**6.** The method of claim 3, 4 or 5, wherein the concentration of the polymer in the aqueous component of the microemulsion phase of the microemulsion system is determined using an equation, the equation comprising:

$$C_{13}^{4} = K\frac{C_4}{C_1} \tag{6}$$

wherein $C_{13}^{4}$ represents the concentration of the polymer in the aqueous component of the microemulsion phase of the microemulsion system.

**7.** The method of any of the preceding claims, wherein (a), (b), (c), or any combination thereof is calculated at every timestep for each cell during a simulation.

**8.** The method of any of the preceding claims, wherein a plurality of chemical enhanced oil recovery scenarios are generated, and wherein operations of a chemical enhanced oil recovery process in the subsurface reservoir are carried out based on a chemical enhanced oil recovery scenario from the plurality of chemical enhanced oil recovery scenarios.

**9.** The method of any of the preceding claims, wherein:

determining the viscosity of the brine phase includes using a polymer viscosity model with the concentration of the polymer in the brine phase as an input into Flory-Huggins and Meter equations; and/or
determining the viscosity of the aqueous component of the microemulsion phase includes using the concentration of the polymer in the aqueous component of the microemulsion phase as input into Flory-Huggins and Meter equations; and/or
determining the viscosity of the microemulsion phase includes using a microemulsion viscosity model corrected for polymer partitioning.

**10.** The method of any of the preceding claims, wherein determining performance of the chemical enhanced oil recovery process scenario comprises forecasting incremental oil recovery.

**11.** The method of any of the preceding claims, wherein the polymer partitioning model is generated based on laboratory data for a sample fluid that forms the microemulsion system and comprises the polymer, an oil, a brine, and a surfactant.

**12.** The method of any of the preceding claims, wherein the chemical enhanced oil recovery scenario is utilized to control operations for a chemical enhanced oil recovery process in the subsurface reservoir.

**13.** The method of claim 12, wherein controlling operations for the chemical enhanced oil recovery process in the subsurface reservoir includes injecting an injection fluid with the polymer into an injection wellbore that is in fluidic communication with the subsurface reservoir, wherein the polymer that is injected has a concentration that was determined by the chemical enhanced oil recovery scenario,
optionally wherein:

the injection fluid with the polymer is injected into the injection wellbore with an injection apparatus; and/or
the injection wellbore is in fluidic communication with a production wellbore such that the injection fluid with the polymer sweeps hydrocarbons in the subsurface reservoir towards the production wellbore.

**14.** A system comprising:

a processor; and
a memory operatively connected to the processor, the memory storing instructions that, when executed by the processor, cause the system to perform a method of determining partitioning of a polymer into phases of a microemulsion system as claimed in any of the preceding claims.

**15.** A computer program that, when executed by a computer, causes the computer to perform a method of determining partitioning of a polymer into phases of a microemulsion system as claimed in any of claims 1 to 13.

STATE OF THE ART

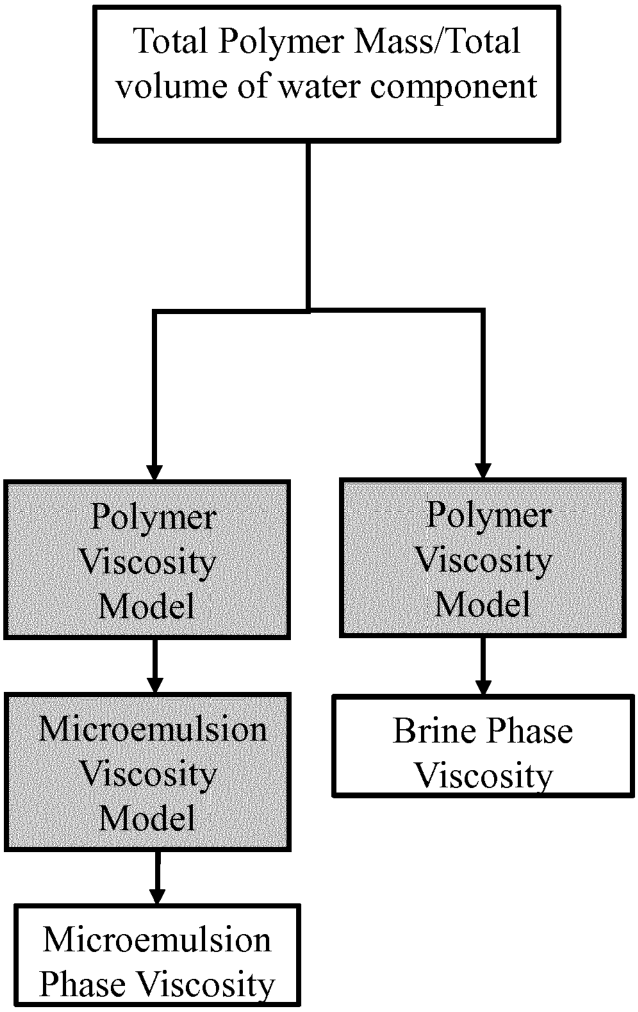


FIG. 1A

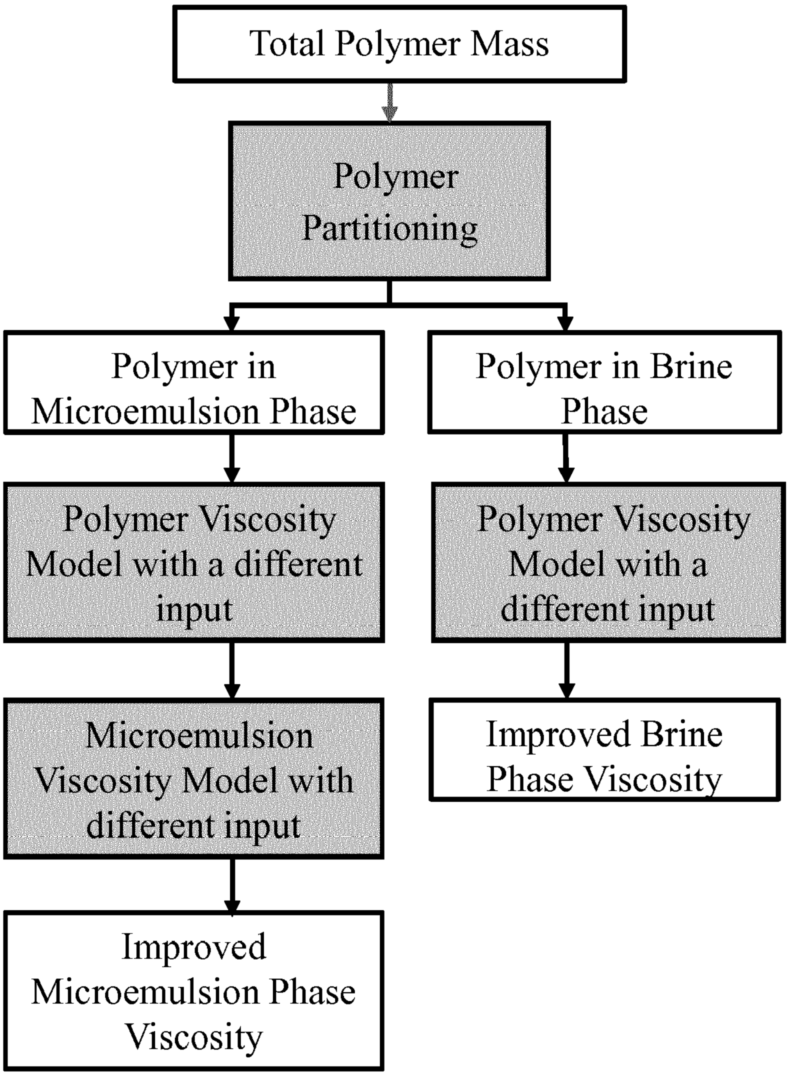
Total Polymer Mass
Polymer Partitioning
Polymer in Microemulsion Phase
Polymer in Brine Phase
Polymer Viscosity Model with a different input
Polymer Viscosity Model with a different input
Microemulsion Viscosity Model with different input
Improved Brine Phase Viscosity
Improved Microemulsion Phase Viscosity

**FIG. 1B**

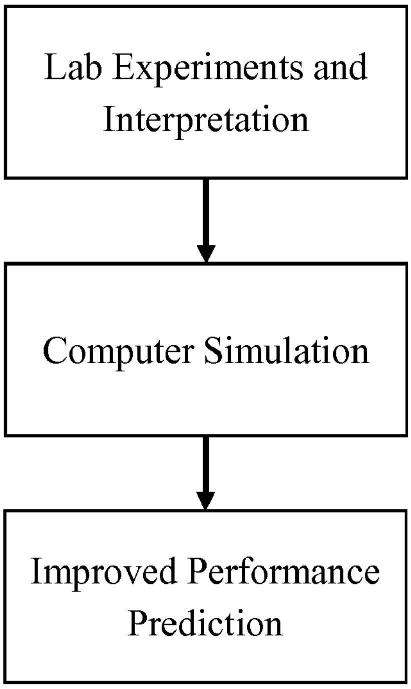
Lab Experiments and Interpretation
Computer Simulation
Improved Performance Prediction

FIG. 1C

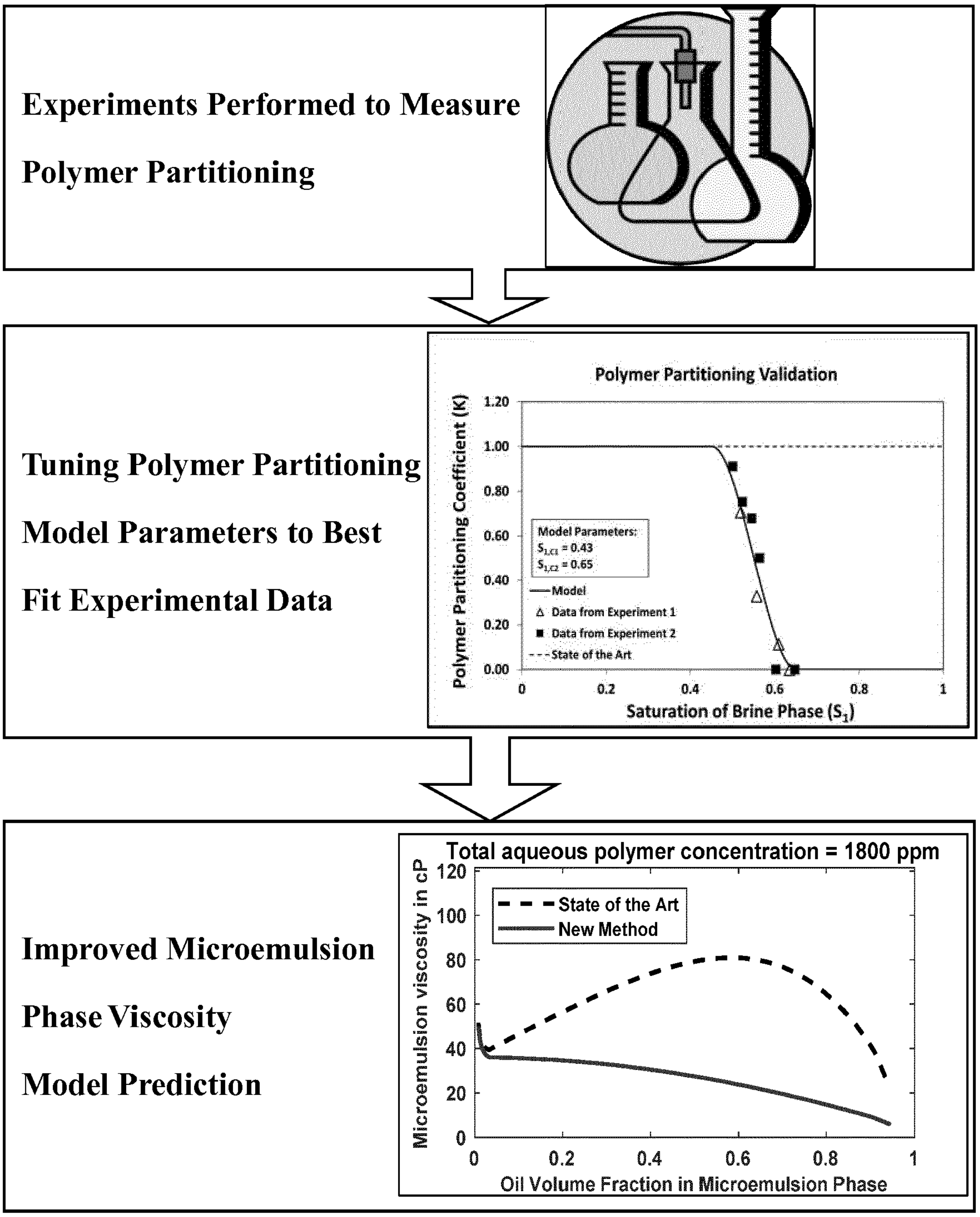

Experiments Performed to Measure Polymer Partitioning
Tuning Polymer Partitioning Model Parameters to Best Fit Experimental Data
Polymer Partitioning Validation
Polymer Partitioning Coefficient (K)
1.20
1.00
0.80
0.60
0.40
0.20
0.00
0
0.2
0.4
0.6
0.8
1
Saturation of Brine Phase (S1)
Model Parameters:
S1,C1 = 0.43
S1,C2 = 0.65
Model
Data from Experiment 1
Data from Experiment 2
State of the Art
Improved Microemulsion Phase Viscosity Model Prediction
Total aqueous polymer concentration = 1800 ppm
Microemulsion viscosity in cP
120
100
80
60
40
20
0
0
0.2
0.4
0.6
0.8
1
Oil Volume Fraction in Microemulsion Phase
State of the Art
New Method


FIG. 1D

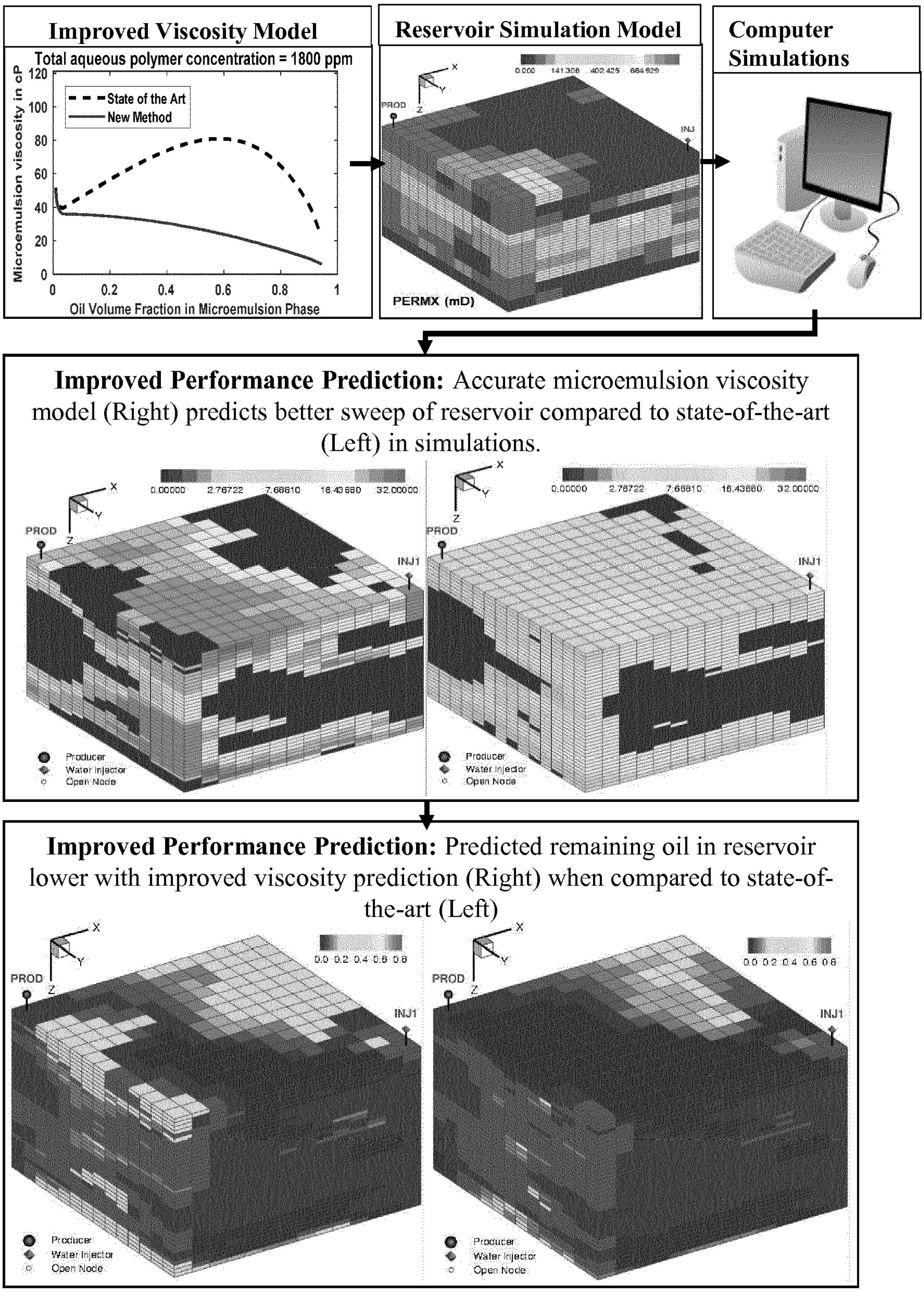
Improved Viscosity Model
Total aqueous polymer concentration = 1800 ppm
State of the Art
New Method
Microemulsion viscosity in cP
120
100
80
60
40
20
0
0
0.2
0.4
0.6
0.8
1
Oil Volume Fraction in Microemulsion Phase
Reservoir Simulation Model
PROD
INJ
PERMX (mD)
Computer Simulations
Improved Performance Prediction: Accurate microemulsion viscosity model (Right) predicts better sweep of reservoir compared to state-of-the-art (Left) in simulations.
0.00000
2.78722
7.66810
16.43660
32.00000
PROD
INJ1
Producer
Water Injector
Open Node
Improved Performance Prediction: Predicted remaining oil in reservoir lower with improved viscosity prediction (Right) when compared to state-of-the-art (Left)
0.0 0.2 0.4 0.6 0.8
PROD
INJ1
Producer
Water Injector
Open Node

FIG. 1E

**Improved Performance Prediction:** Predicted remaining oil in reservoir lower with improved viscosity prediction (Right) when compared to state-of-the-art (Left)

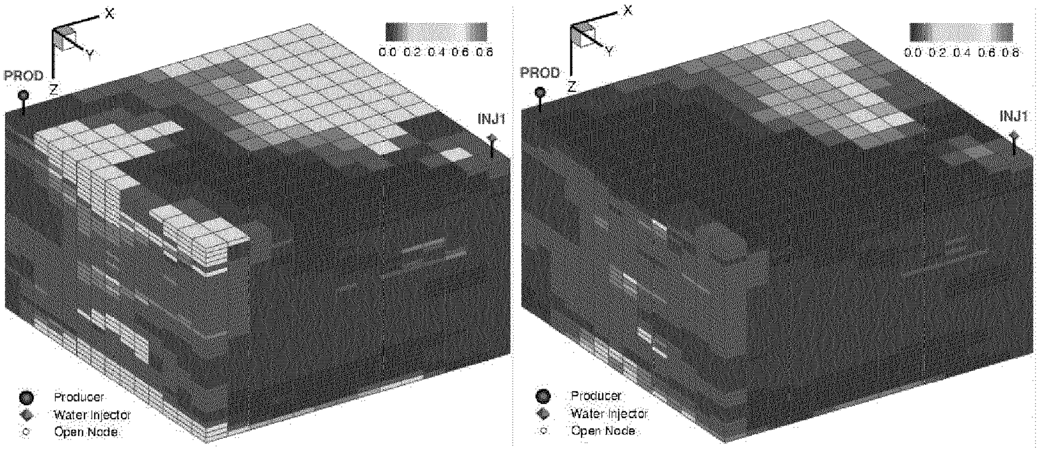


Better oil recovery prediction in CEOR after water flood (WF) with improved viscosity (solid) vs state of the art (dashed): 2.7 % higher cumulative oil recovery

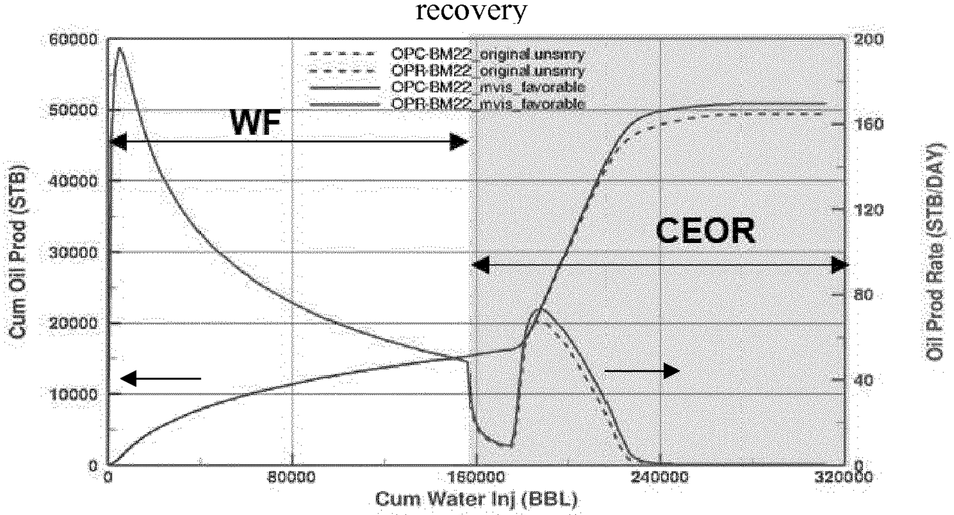


Improved Field Recovery Estimates, Process Design and Economic Evaluation for CEOR processes

**FIG. 1F**

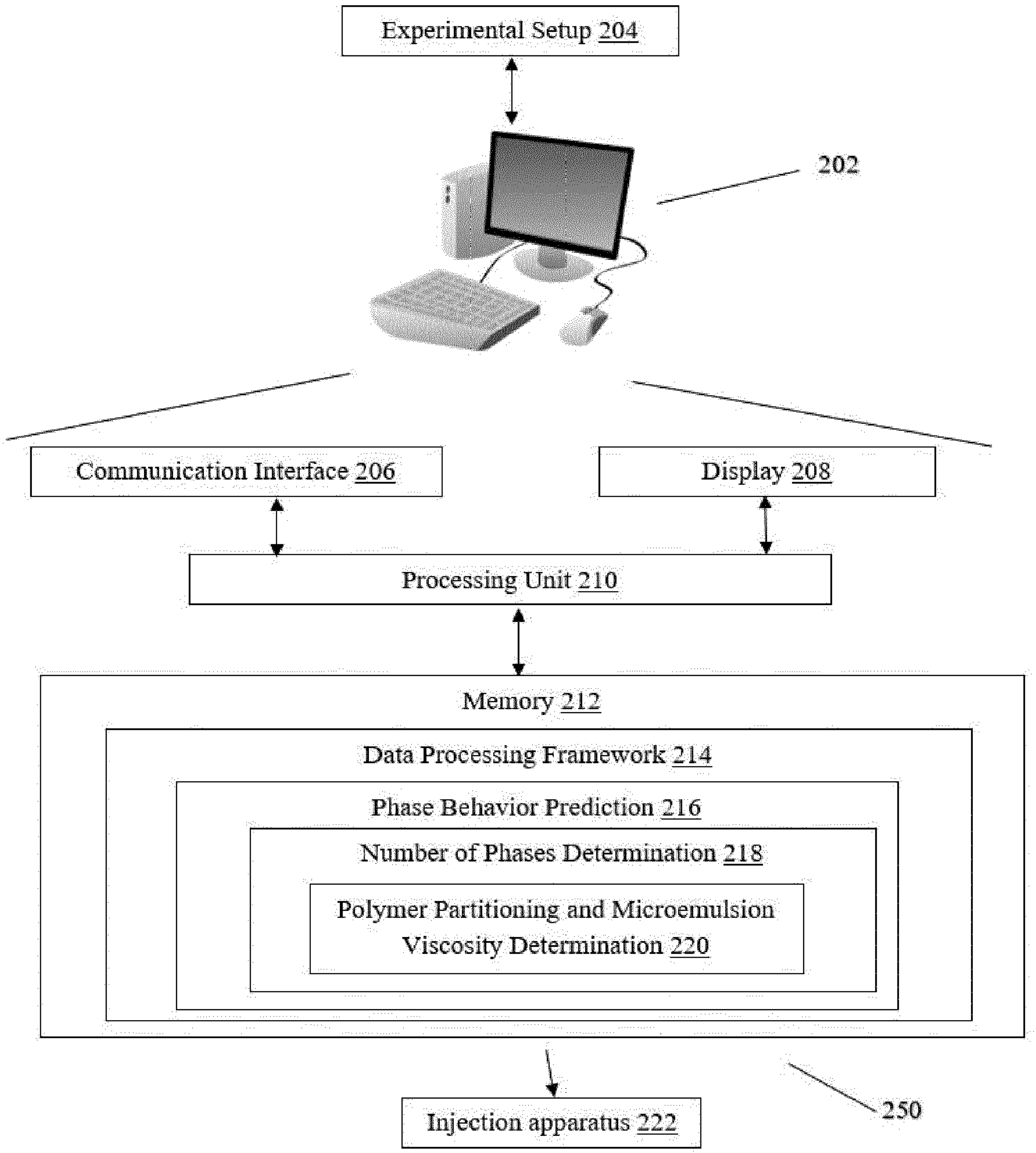
Experimental Setup 204
202
Communication Interface 206
Display 208
Processing Unit 210
Memory 212
Data Processing Framework 214
Phase Behavior Prediction 216
Number of Phases Determination 218
Polymer Partitioning and Microemulsion Viscosity Determination 220
Injection apparatus 222
250

**FIG. 2**

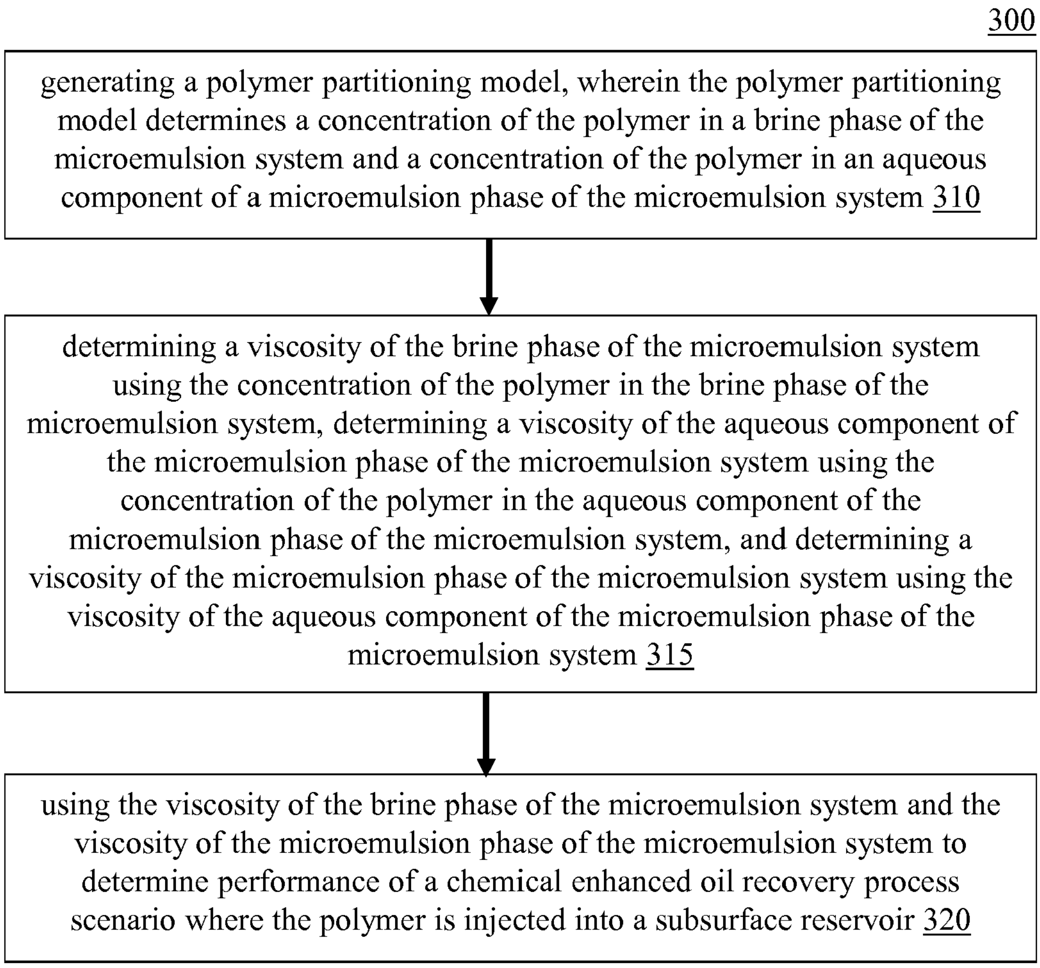
300
generating a polymer partitioning model, wherein the polymer partitioning model determines a concentration of the polymer in a brine phase of the microemulsion system and a concentration of the polymer in an aqueous component of a microemulsion phase of the microemulsion system 310
determining a viscosity of the brine phase of the microemulsion system using the concentration of the polymer in the brine phase of the microemulsion system, determining a viscosity of the aqueous component of the microemulsion phase of the microemulsion system using the concentration of the polymer in the aqueous component of the microemulsion phase of the microemulsion system, and determining a viscosity of the microemulsion phase of the microemulsion system using the viscosity of the aqueous component of the microemulsion phase of the microemulsion system 315
using the viscosity of the brine phase of the microemulsion system and the viscosity of the microemulsion phase of the microemulsion system to determine performance of a chemical enhanced oil recovery process scenario where the polymer is injected into a subsurface reservoir 320

**FIG. 3**

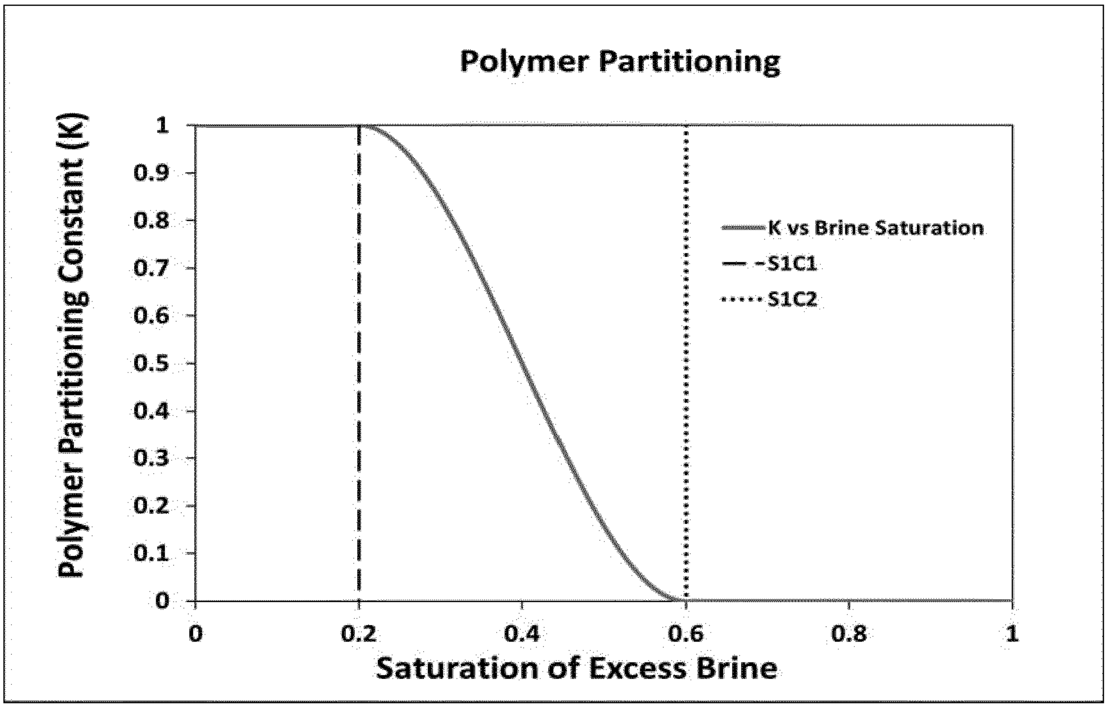
Polymer Partitioning
Polymer Partitioning Constant (K)
1
0.9
0.8
0.7
0.6
0.5
0.4
0.3
0.2
0.1
0
0
0.2
0.4
0.6
0.8
1
Saturation of Excess Brine
K vs Brine Saturation
S1C1
S1C2

FIG. 4

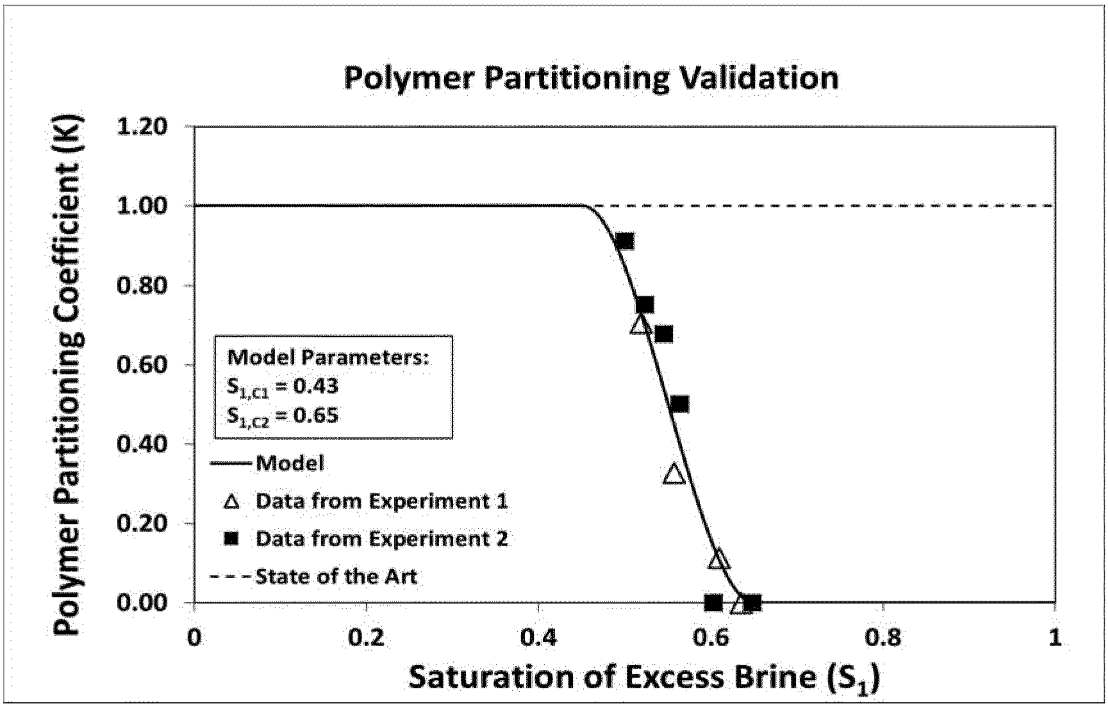
Polymer Partitioning Validation
Polymer Partitioning Coefficient (K)
1.20
1.00
0.80
0.60
0.40
0.20
0.00
0
0.2
0.4
0.6
0.8
1
Saturation of Excess Brine ($S_1$)
Model Parameters:
$S_{1,C1}$ = 0.43
$S_{1,C2}$ = 0.65
Model
Data from Experiment 1
Data from Experiment 2
State of the Art

FIG. 5

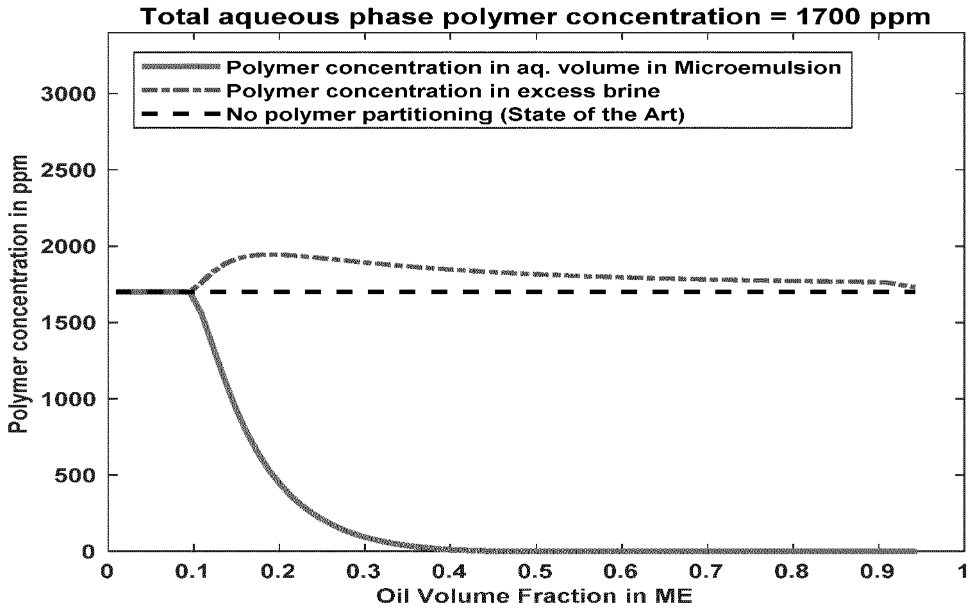
Total aqueous phase polymer concentration = 1700 ppm
Polymer concentration in aq. volume in Microemulsion
Polymer concentration in excess brine
No polymer partitioning (State of the Art)
Polymer concentration in ppm
3000
2500
2000
1500
1000
500
0
0
0.1
0.2
0.3
0.4
0.5
0.6
0.7
0.8
0.9
1
Oil Volume Fraction in ME

FIG. 6A

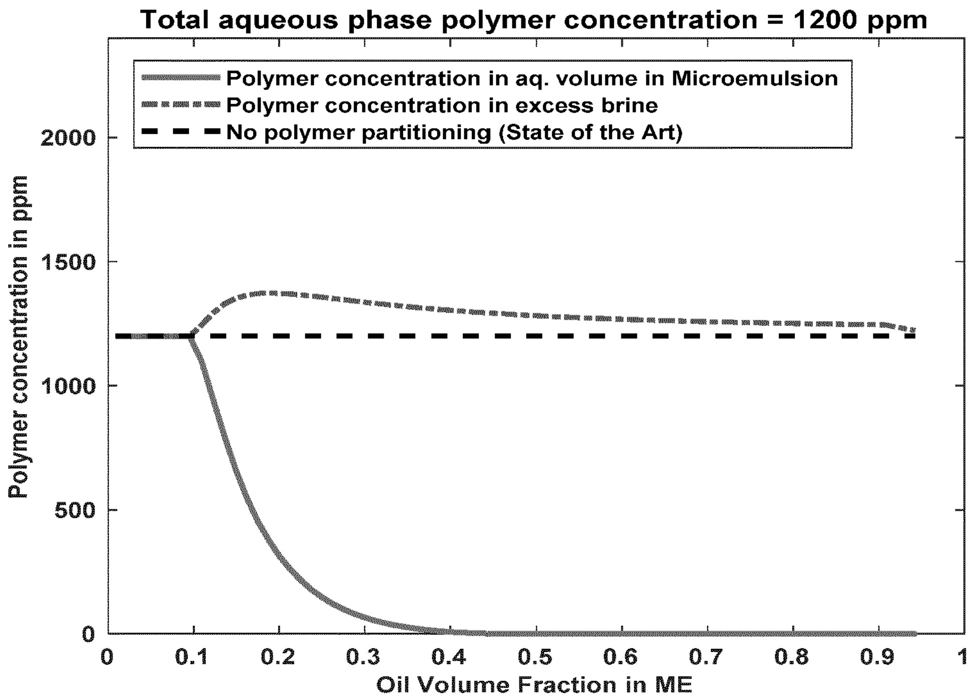
Total aqueous phase polymer concentration = 1200 ppm
Polymer concentration in aq. volume in Microemulsion
Polymer concentration in excess brine
No polymer partitioning (State of the Art)
Polymer concentration in ppm
2000
1500
1000
500
0
0
0.1
0.2
0.3
0.4
0.5
0.6
0.7
0.8
0.9
1
Oil Volume Fraction in ME

FIG. 6B

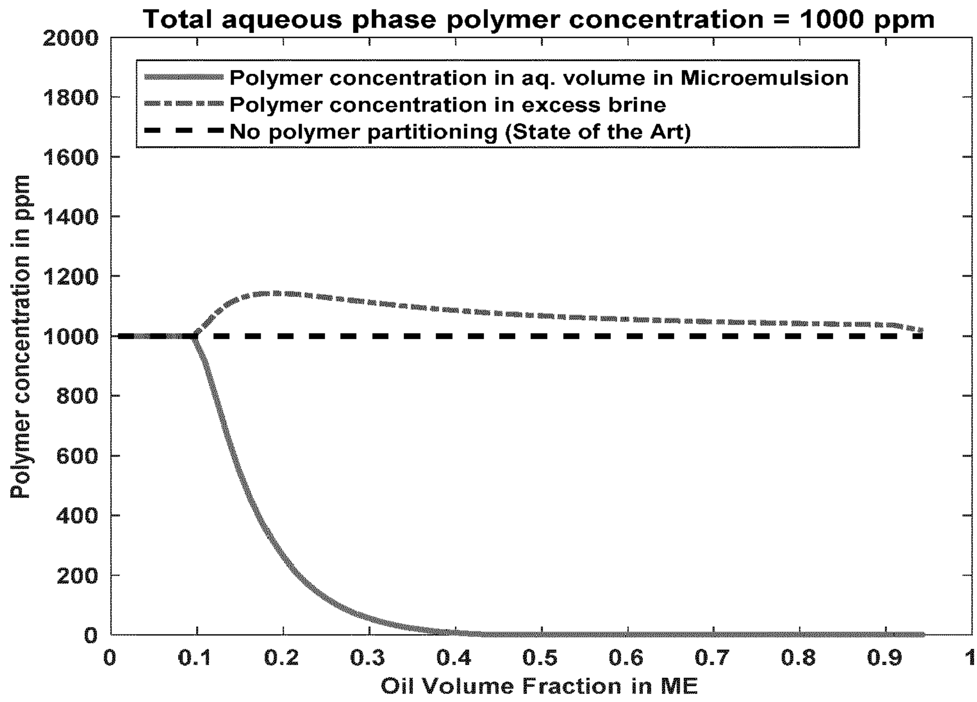
Total aqueous phase polymer concentration = 1000 ppm
Polymer concentration in aq. volume in Microemulsion
Polymer concentration in excess brine
No polymer partitioning (State of the Art)
Polymer concentration in ppm
2000
1800
1600
1400
1200
1000
800
600
400
200
0
0
0.1
0.2
0.3
0.4
0.5
0.6
0.7
0.8
0.9
1
Oil Volume Fraction in ME

FIG. 6C

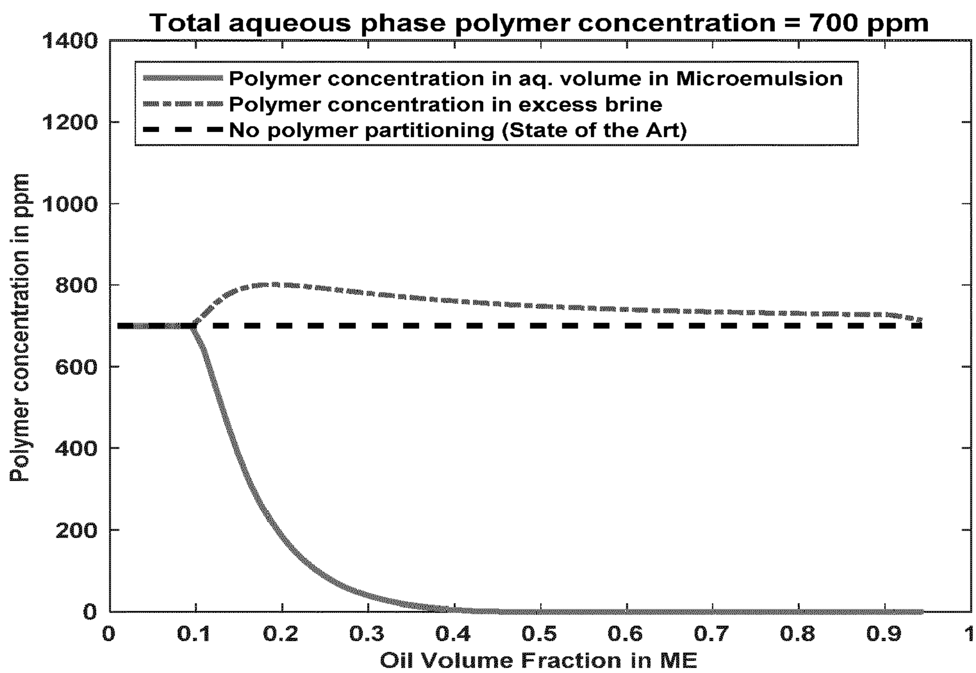
Total aqueous phase polymer concentration = 700 ppm
Polymer concentration in aq. volume in Microemulsion
Polymer concentration in excess brine
No polymer partitioning (State of the Art)
Polymer concentration in ppm
1400
1200
1000
800
600
400
200
0
0
0.1
0.2
0.3
0.4
0.5
0.6
0.7
0.8
0.9
1
Oil Volume Fraction in ME

FIG. 6D

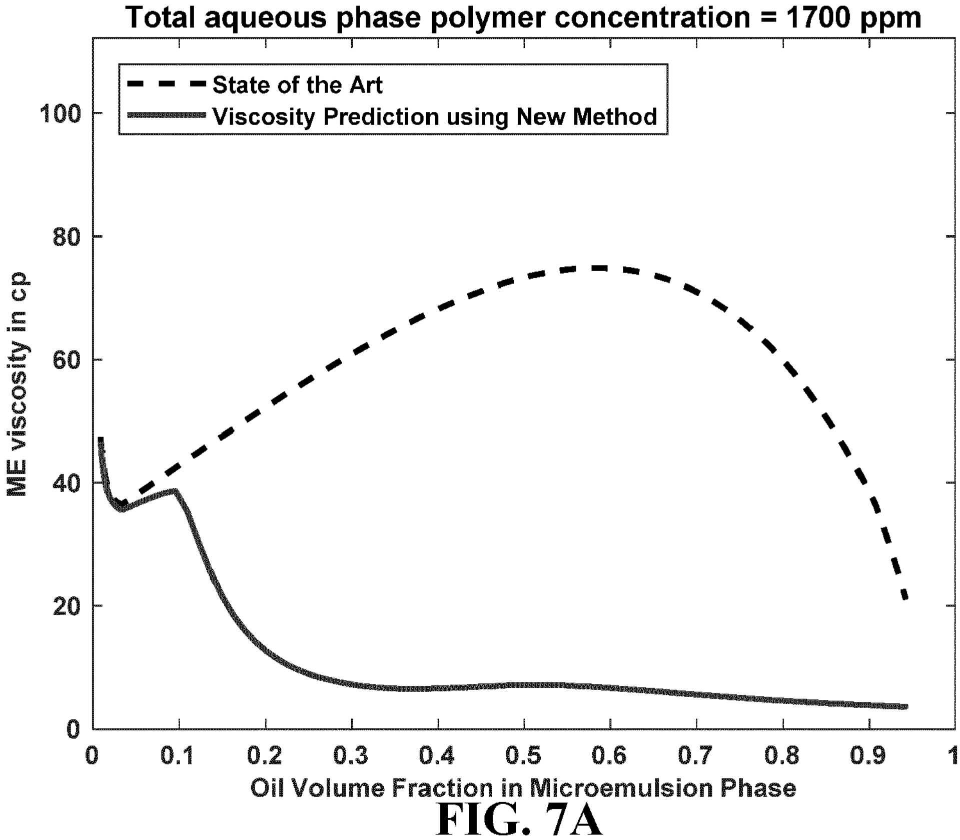
Total aqueous phase polymer concentration = 1700 ppm
State of the Art
Viscosity Prediction using New Method
ME viscosity in cp
0
20
40
60
80
100
0
0.1
0.2
0.3
0.4
0.5
0.6
0.7
0.8
0.9
1
Oil Volume Fraction in Microemulsion Phase

FIG. 7A

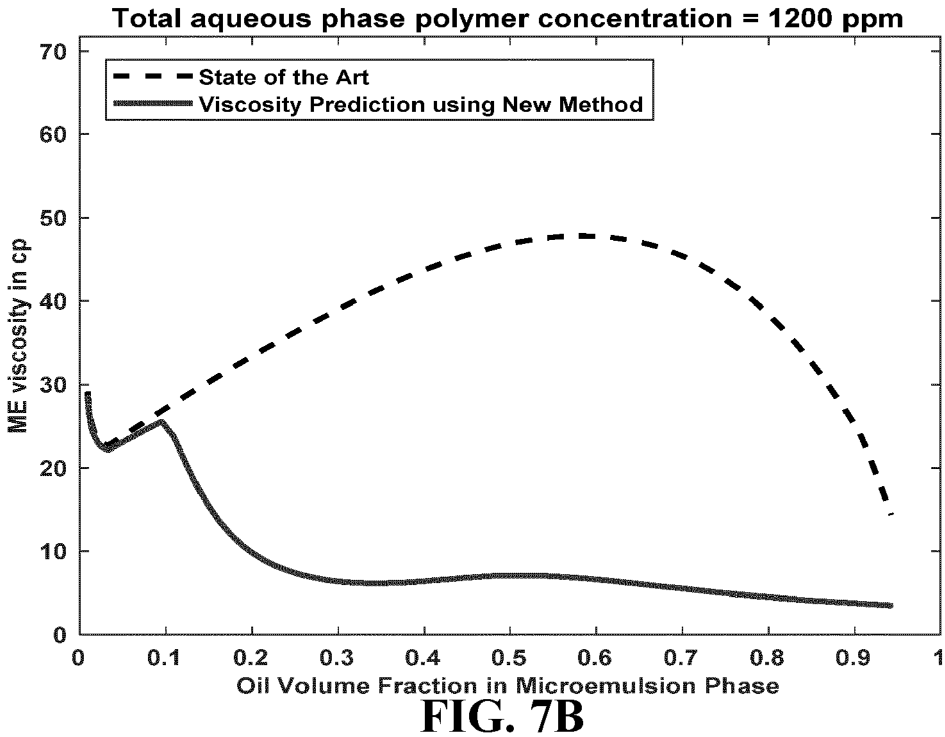
Total aqueous phase polymer concentration = 1200 ppm
State of the Art
Viscosity Prediction using New Method
ME viscosity in cp
0
10
20
30
40
50
60
70
0
0.1
0.2
0.3
0.4
0.5
0.6
0.7
0.8
0.9
1
Oil Volume Fraction in Microemulsion Phase

FIG. 7B

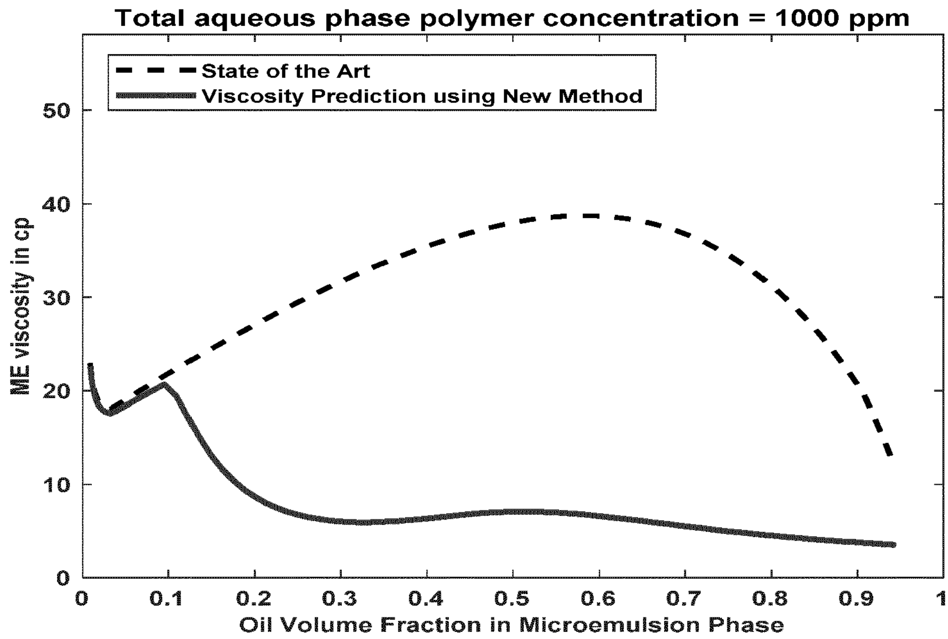
Total aqueous phase polymer concentration = 1000 ppm
State of the Art
Viscosity Prediction using New Method
ME viscosity in cp
0
10
20
30
40
50
0
0.1
0.2
0.3
0.4
0.5
0.6
0.7
0.8
0.9
1
Oil Volume Fraction in Microemulsion Phase

FIG. 7C

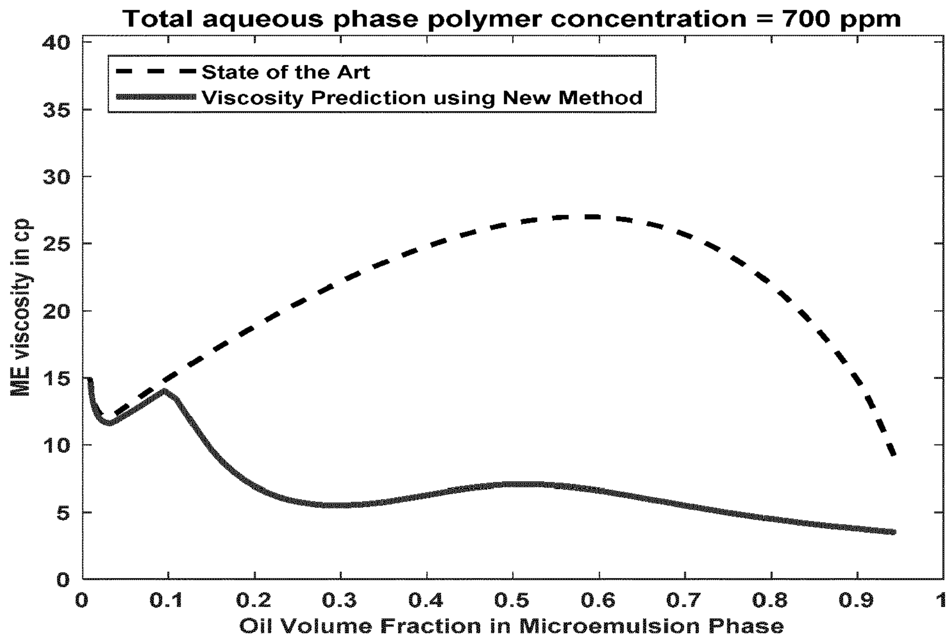
Total aqueous phase polymer concentration = 700 ppm
State of the Art
Viscosity Prediction using New Method
ME viscosity in cp
0
5
10
15
20
25
30
35
40
0
0.1
0.2
0.3
0.4
0.5
0.6
0.7
0.8
0.9
1
Oil Volume Fraction in Microemulsion Phase

FIG. 7D

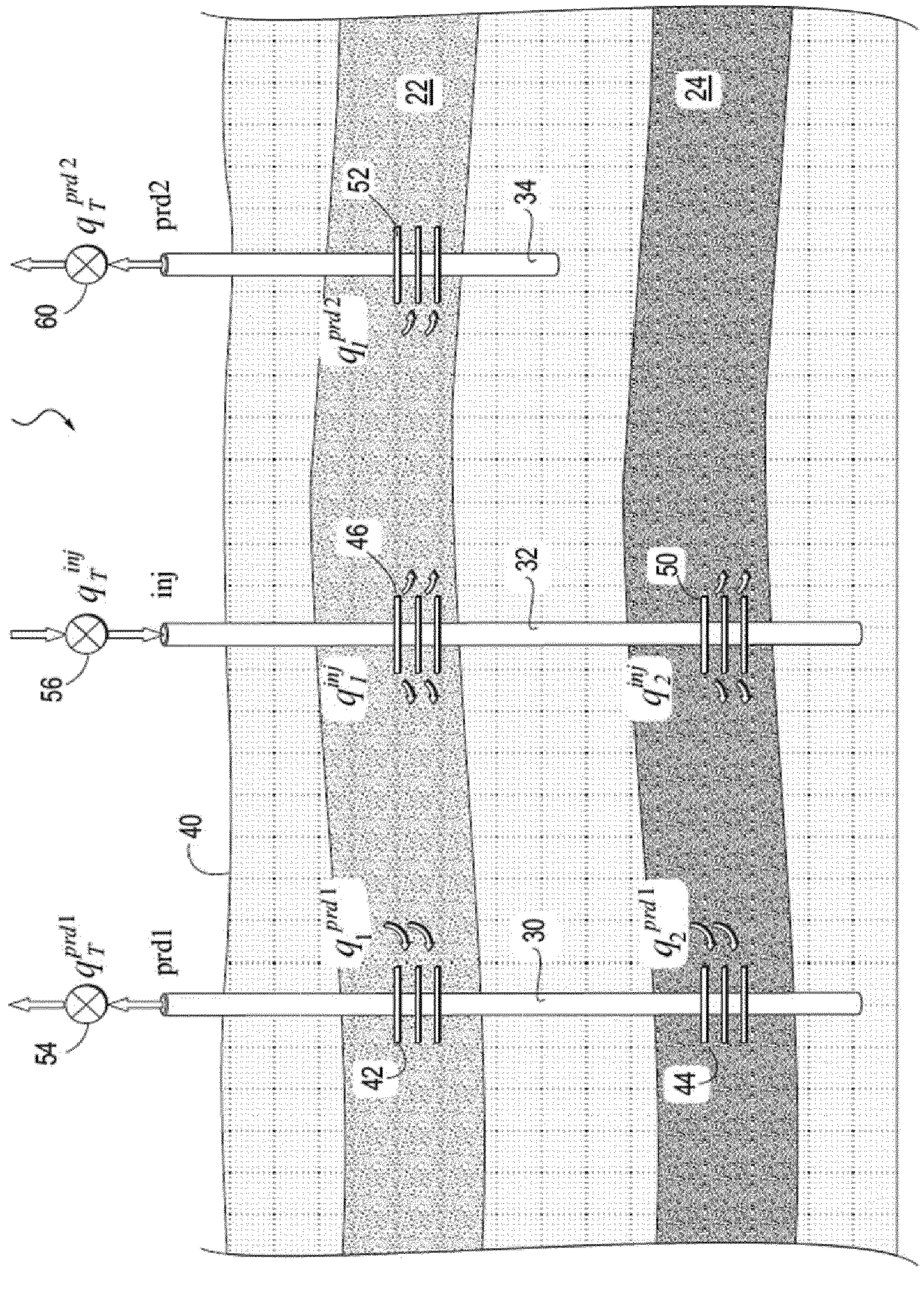


FIG. 8

Europäisches Patentamt
European Patent Office
Office européen des brevets

# EUROPEAN SEARCH REPORT

Application Number
EP 19 17 0334

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | N. FATHI NAJAFABADI ET AL: "Formulations for a three-phase, fully implicit, parallel, EOS compositional surfactant-polymer flooding simulator", JOURNAL OF PETROLEUM SCIENCE AND ENGINEERING, vol. 86-87, 1 May 2012 (2012-05-01), pages 257-271, XP55614527, NL ISSN: 0920-4105, DOI: 10.1016/j.petrol.2012.03.025 * abstract * * page 258, paragraph 2. Model assumptions * * page 270, paragraph A.8 Viscosity * * pages 263-268 * * page 263, paragraph 7. Parallel computation and linear solver * ----- | 1-15 | INV. C09K8/584 C09K8/588 E21B43/16 |
| A | US 2009/070085 A1 (GULLAPALLI IRENE LEE [US] ET AL) 12 March 2009 (2009-03-12) * paragraphs [0006] - [0009], [0016], [0024] - [0039], [0043], [0047], [0059], [0068] - [0072], [0077]; claim 1 * ----- | 1-15 | TECHNICAL FIELDS SEARCHED (IPC) C09K E21B |
| A | US 4 676 315 A (BRAGG JAMES R [US]) 30 June 1987 (1987-06-30) * column 2, line 36 - column 3, line 45; claim 1 * * column 6, lines 50-59; table II * ----- | 1-15 | |

The present search report has been drawn up for all claims

1

| Place of search | Date of completion of the search | Examiner |
|---|---|---|
| Munich | 23 August 2019 | Redecker, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 19 17 0334

This annex lists the patent family members relating to the patent documents cited in the above-mentioned European search report. The members are as contained in the European Patent Office EDP file on The European Patent Office is in no way liable for these particulars which are merely given for the purpose of information.

23-08-2019

| Patent document cited in search report | Publication date | Patent family member(s) | Publication date |
|---|---|---|---|
| US 2009070085 A1 | 12-03-2009 | AU 2008299208 A1 | 19-03-2009 |
| | | GB 2465941 A | 09-06-2010 |
| | | US 2009070085 A1 | 12-03-2009 |
| | | US 2011246164 A1 | 06-10-2011 |
| | | WO 2009035897 A1 | 19-03-2009 |
| US 4676315 A | 30-06-1987 | CA 1284693 C | 04-06-1991 |
| | | DE 3702077 A1 | 06-08-1987 |
| | | FR 2593722 A1 | 07-08-1987 |
| | | GB 2187653 A | 16-09-1987 |
| | | NO 173254 B | 09-08-1993 |
| | | US 4676315 A | 30-06-1987 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 62660746 A
- US 9909053 B
- US 9896617 B
- US 9902894 B
- US 9902895 B
- US 20180031462 A
- US 511563 A
- WO 2017040903 A1
- US 9284826 B
- US 9840898 B
- US 20140288909 A
- US 20170058186 A
- US 62557029 A
- US 62561929 B
- US 20190079066 A
- US 20190094199 A


### Non-patent literature cited in the description


- **DWARAKANATH et al.** Permeability Reduction Due to use of Liquid Polymers and Development of Remediation Options. *SPE 179657, SPE IOR Symposium in Tulsa,* 2016
- Measurement of microemulsion viscosity and its implications for chemical EOR. **TAGAVIFAR, M. ; HERATH, S. ; WEERASOORIYA, U. P. ; SEPEHRNOORI, K. ; POPE, G.** SPE Improved Oil Recovery Conference. Society of Petroleum Engineers, April 2016
- Technical Documentation for UTCHEM 2015, A Three-Dimensional Chemical Flood Simulator. **DELSHAD, M. ; POPE, G. A. ; SEPEHRNOORI, K.** Technical Documentation. Center for Petroleum and Geosystems Engineering, The University of Texas at Austin, 2015, vol. II
- Proper Simulation of Chemical EOR (CEOR) Pilots - A Real Case Study. SPE-179659-MS. **NAJAFABADI, N.F. ; CHAWATHE, A.** SPE Improved Oil Recovery Conference. Society of Petroleum Engineers, 2016
- **POPE, G. A. ; TSAUR, K. ; SCHECHTER, R. S. ; WANG, B.** The effect of several polymers on the phase behavior of micellar fluids. *Society of Petroleum Engineers Journal,* 1982, vol. 22 (06), 816-830
- **FLORY, P.J.** Principles of Polymer Chemistry. Cornell University Press, 1953
- **METER, D.M. ; BIRD, R.B.** Tube Flow of Non-Newtonian Polymer Solutions, Parts I and II Laminar Flow and Rheological Models. *AIChE J.,* 1964, 878-881, 1143-1150
- Measurement of microemulsion viscosity and its implications for chemical EOR. SPE-179659-MS. **TAGAVIFAR, M. ; HERATH, S. ; WEERASOORIYA, U. P. ; SEPEHRNOORI, K. ; POPE, G.** SPE Improved Oil Recovery Conference. Society of Petroleum Engineers, April 2016